# EUROPEAN PATENT APPLICATION

(11) **EP 4 280 291 A1**
(43) Date of publication of application: **22.11.2023**
(21) Application number: 22739841.9
(22) Date of filing: 18.01.2022
(51) Int. Cl.: H01L 33/58, H01L 33/62, H01L 33/20, H01L 33/56, H01L 33/54, H01L 25/075, H01L 33/60

(54) **LIGHT EMITTING DEVICE**

(30) Priority: 18.01.2021 KR 20210006579
(71) Applicant: Seoul Semiconductor Co., Ltd., Gyeonggi-do 15429 (KR)
(72) Inventor: SON, Junghun, Ansan-Si Gyeonggi-do 15429 (KR); KIM, Hyein, Ansan-Si Gyeonggi-do 15429 (KR); HAN, Junga, Ansan-Si Gyeonggi-do 15429 (KR); SONG, Inbeom, Ansan-Si Gyeonggi-do 15429 (KR)
(74) Representative: Isarpatent
(86) International application number: PCT/KR2022/000943
(87) International publication number: WO 2022/154649

(57) **Abstract**

A light emitting device may comprise: a substrate on which a conductive pattern is formed; a light emitting part comprising at least one light emitting chip; a light transmitting member formed on the upper surface of the light emitting part; and a barrier member. The light transmitting member comprises a pair of first side surfaces and a different pair of second side surfaces that face each other, and with respect to the lower surface, the first side surfaces may be formed at a first angle and the second side surfaces may be formed at a second angle, and the first angle may be smaller than the second angle. The barrier member may be formed on the top of the substrate so as to cover the side surfaces and the upper surface of the light emitting part and the side surfaces of the light transmitting a member, and the light transmitting member has a cross-sectional area that decreases from the lower surface thereof toward the upper surface thereof so that the lower surface has a smaller area than the upper surface of the light emitting part, and may be positioned in an upper surface region of the light emitting part.

## Description

### CROSS REFERENCE TO RELATED APPLICATION

This application is the National Stage Entry of International Patent Application No. PCT/KR2022/000943, filed on January 18, 2022, and claims priority from and the benefit of Korean Patent Application No. 10-2021-0006579, filed on January 18, 2021, and Korean Patent Application No. 10-2022-0007501, filed on January 18, 2022, each of which is incorporated by reference for all purposes as if fully set forth herein.

### BACKGROUND

### FIELD

The present invention relates to a light emitting device.

### DISCUSSION OF THE BACKGROUND

A light emitting chip is a semiconductor device that emits light through recombination of electrons and holes and is recently applied to various fields including displays, vehicular headlamps, general lighting, and the like. Since the light emitting chip has long lifespan, low power consumption, and rapid response, the light emitting chip is applied to various fields.

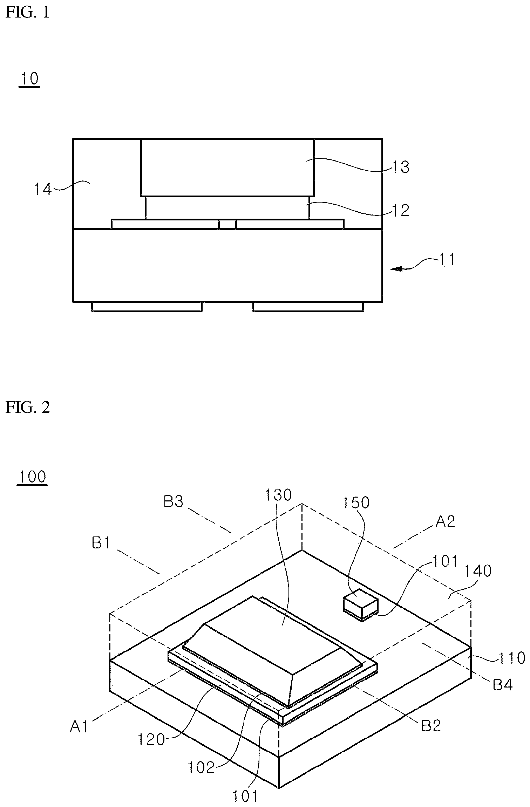

FIG. 1 is a sectional view of a typical light emitting device 10 for headlamps. Referring to FIG. 1, the light emitting device 10 includes a substrate 11, a light emitting chip 12, a light transmitting member 13, and a barrier member 14.

The light transmitting member 13 of the typical light emitting device 10 covers the entire upper surface of the light emitting chip 12. That is, a lower surface of the light transmitting member 13 may have the same area as or a larger area than an upper surface of the light emitting chip 12.

In addition, the light transmitting member 13 has a structure wherein upper and lower surfaces thereof have the same area. Accordingly, a light exit surface of the light transmitting member 13 corresponds to the upper surface thereof and has the same area as or a larger area than the upper surface of the light emitting chip 12.

Since such a typical light emitting device 10 emits light through the light exit surface having a large area, light emitted from the light emitting device travels a short distance to arrive at a target.

Accordingly, when the typical light emitting device 10 is applied to a headlamp, the headlamp cannot secure sufficient visibility for drivers.

### SUMMARY

Embodiments of the present invention provide a light emitting device capable of improving straightness of light.

Embodiments of the present invention provide a light emitting device capable of minimizing light loss while improving straightness of light.

According to embodiments of the present invention, there is provided a light emitting device including a substrate having an electrically conductive pattern formed thereon, a light emitting part, and a light transmitting member and a barrier member formed on an upper surface of the light emitting part.

The light emitting part may include at least one light emitting chip mounted on the substrate and electrically connected to the electrically conductive pattern.

The light transmitting member may include a pair of first side surfaces facing each other and a pair of second side surfaces facing each other. The first side surfaces of the light transmitting member may be inclined at a first angle with respect to a lower surface of the light transmitting member. In addition, the second side surfaces of the light transmitting member may be inclined at a second angle with respect to the lower surface of the light transmitting member. The first angle may be smaller than the second angle.

The barrier member may be formed on an upper surface of the substrate to cover side surfaces and an upper surface of the light emitting part and side surfaces of the light transmitting member.

The light transmitting member may have a cross-sectional area gradually decreasing from the lower surface thereof to an upper surface thereof.

The lower surface of the light transmitting member has a smaller area than the upper surface of the light emitting part and may be placed in an upper surface region of the light emitting part.

The light emitting device according to some embodiments of the present invention includes a light transmitting member having a cross-sectional area gradually decreasing from a lower surface to an upper surface thereof, thereby improving straightness of light.

In addition, the light emitting device according to other embodiments of the present invention includes a reflective member surrounding side surfaces of the light transmitting member, thereby minimizing light loss while improving straightness of light.

### BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the inventive concepts.
FIG. 1 is a sectional view of a typical light emitting device applied to a headlamp.
FIG. 2 is a perspective view of a light emitting device according to a first embodiment of the present invention.
FIG. 3 is a bottom view of the light emitting device according to the first embodiment of the present invention.
FIG. 4 is a cross-sectional view (A1-A2) of the light emitting device according to the first embodiment of the present invention.
FIG. 5 is another cross-sectional view (B1-B2) of the light emitting device according to the first embodiment of the present invention.
FIG. 6 is a further cross-sectional view (B3-B4) of the light emitting device according to the first embodiment of the present invention.
FIG. 7 is a plan view of the light emitting device according to the first embodiment of the present invention.
FIG. 8 is a perspective view of a light emitting device according to a second embodiment of the present invention.
FIG. 9 is a cross-sectional view (C1-C2) of the light emitting device according to the second embodiment of the present invention.
FIG. 10 is another cross-sectional view (D1-D2) of the light emitting device according to the second embodiment of the present invention.
FIG. 11 is an exemplary view of a light emitting device according to a third embodiment of the present invention.
FIG. 12 is a plan view of a light emitting device according to a fourth embodiment of the present invention.
FIG. 13 is a cross-sectional view (E1-E2) of the light emitting device according to the fourth embodiment of the present invention.
FIG. 14 is another cross-sectional view (F1-F2) of the light emitting device according to the fourth embodiment of the present invention.
FIG. 15 is a plan view of a light emitting device according to a fifth embodiment of the present invention.
FIG. 16 is a cross-sectional view (G1-G2) of the light emitting device according to the fifth embodiment of the present invention.
FIG. 17 is another cross-sectional view (H1-H2) of the light emitting device according to the fifth embodiment of the present invention.
FIG. 18 is an exemplary view of a light transmitting member according to an embodiment of the present invention.
FIG. 19 is an SEM (Scanning Electron Microscope) image of a cross-section of the light transmitting member according to the embodiment of the present invention.
FIG. 20 is an enlarged SEM image of a portion P of the light transmitting member according to the embodiment of the present invention.
FIG. 22 is a graph comparing light spectra of a third light emitting device and a fourth light emitting device.
FIG. 23 is a graph depicting color coordinates of cyan phosphors according to various embodiments of the present invention.
FIG. 24 is a plan view of a light emitting device according to a sixth embodiment of the present invention.
FIG. 25 is a cross-sectional view (11-12) of the light emitting device according to the sixth embodiment of the present invention.
FIG. 26 is an exemplary view of a light emitting device according to a seventh embodiment of the present invention.
FIG. 27 is an exemplary view of a light emitting device according to an eighth embodiment of the present invention.
FIG. 28 is a plan view of a light emitting device according to a ninth embodiment of the present invention.
FIG. 29 is a cross-sectional view (J1-J2) of the light emitting device according to the ninth embodiment of the present invention.
FIG. 30 is another cross-sectional view (J3-J3) of the light emitting device according to the ninth embodiment of the present invention.
FIG. 31 is an exemplary view of a light emitting device according to a tenth embodiment of the present invention.
FIG. 32 is an exemplary view of a light emitting device according to an eleventh embodiment of the present invention.
FIG. 33 is an exemplary view of a light emitting device according to a twelfth embodiment of the present invention.
FIG. 34 is an exemplary view of a light emitting device according to a thirteenth embodiment of the present invention.

### DETAILED DESCRIPTION

Hereinafter, embodiments of the present invention will be described with reference to the accompanying drawings. It should be understood that the following embodiments are provided for complete disclosure and thorough understanding of the present invention by those skilled in the art. Therefore, the present invention is not limited to the following embodiments and may be embodied in different ways. In addition, the drawings may be exaggerated in width, length, and thickness of components for descriptive convenience and clarity only. Like components will be denoted by like reference numerals throughout the specification.

According to embodiments of the present invention, a light emitting device may include a substrate having an electrically conductive pattern formed thereon, a light emitting part, and a light transmitting member and a barrier member formed on an upper surface of the light emitting part.

The light emitting part may include at least one light emitting chip mounted on the substrate and electrically connected to the electrically conductive pattern.

The light transmitting member may include a pair of first side surfaces facing each other and a pair of second side surfaces facing each other. The first side surfaces of the light transmitting member may be inclined at a first angle with respect to a lower surface of the light transmitting member. In addition, the second side surfaces of the light transmitting member may be inclined at a second angle with respect to the lower surface of the light transmitting member. The first angle may be smaller than the second angle.

The barrier member may be formed on an upper surface of the substrate to cover an upper surface and side surfaces of the light emitting part and the side surfaces of the light transmitting member.

The light transmitting member may have a cross-sectional area gradually decreasing from the lower surface thereof to an upper surface thereof.

The lower surface of the light transmitting member may have a smaller area than the upper surface of the light emitting part and may be placed in an upper surface region of the light emitting part.

The light emitting chip may include a pair of first side surfaces and a pair of second side surfaces. Here, an upper end of the first side surfaces of the light emitting chip may be parallel to a lower end of the first side surfaces of the light transmitting member. In addition, an upper end of the second side surfaces of the light emitting chip may be parallel to a lower end of the second side surfaces of the light transmitting member.

According to one embodiment, the light emitting part may include a first light emitting chip.

A distance between the lower end of the first side surfaces of the light transmitting member and the upper end of the first side surfaces of the first light emitting chip may be greater than a distance between the lower end of the second side surfaces of the light transmitting member and the upper surface of the second side surfaces of the first light emitting chip.

According to another embodiment, the light emitting part may include multiple light emitting chips.

The multiple light emitting chips may be connected to each other in series or in parallel by the electrically conductive pattern of the substrate.

In addition, the multiple light emitting chips may be arranged side by side in one direction.

The light emitting part may include a first light emitting chip and a second light emitting chip.

A distance between a lower end of the first side surfaces of the light transmitting member and an upper end of the first side surfaces of the first light emitting chip and the second light emitting chip may be the same as or greater than a distance between a lower end of the second side surfaces of the light transmitting member and an upper end of the second side surfaces of the first light emitting chip and the second light emitting chip.

The light emitting part may further include a third light emitting chip.

A distance between a lower end of the first side surfaces of the light transmitting member and an upper end of the first side surfaces of the first to third light emitting chips may be smaller than a distance between a lower end of the second side surface of the light transmitting member and an upper end of the second side surfaces of the first to third light emitting chips.

The light transmitting member may further include glass or ceramics and a wavelength conversion material dispersed in the glass or the ceramics.

The light transmitting member may include a wavelength conversion layer and a protective layer. The wavelength conversion layer may include a wavelength conversion material. In addition, the protective layer may be disposed on the wavelength conversion layer.

The light emitting device may further include a reflective member covering the side surfaces of the light transmitting member.

The reflective member may cover a portion of the upper surface of the light emitting chip and may have a thickness gradually increasing from an upper portion to a lower portion thereof to form an inclined side surface.

The side surface of the reflective member may include a downwardly concave surface.

An upper end of the reflective member may be placed at a point two-thirds of a height from the lower surface of the light transmitting member to the upper surface thereof.

The reflective member may reflect light emitted through an upper surface of the light emitting part placed outside the light transmitting member towards the light transmitting member.

The reflective member may be a silicone member.

A side surface of the barrier member may be placed collinear with a side surface of the substrate.

The side surface of the light transmitting member may be perpendicular to the upper surface of the light emitting chip.

Hereinafter, various embodiments of the present invention will be described with reference to the accompanying drawings.

FIG. 2 to FIG. 7 are exemplary views of a light emitting device according to a first embodiment of the present invention.

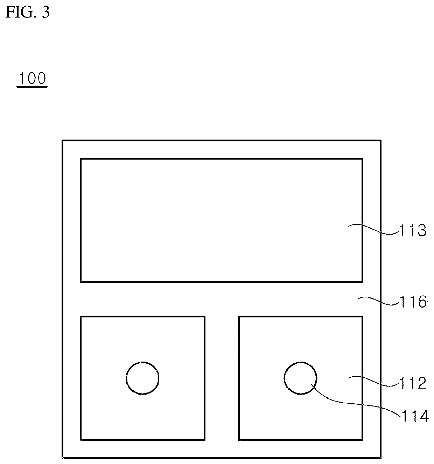

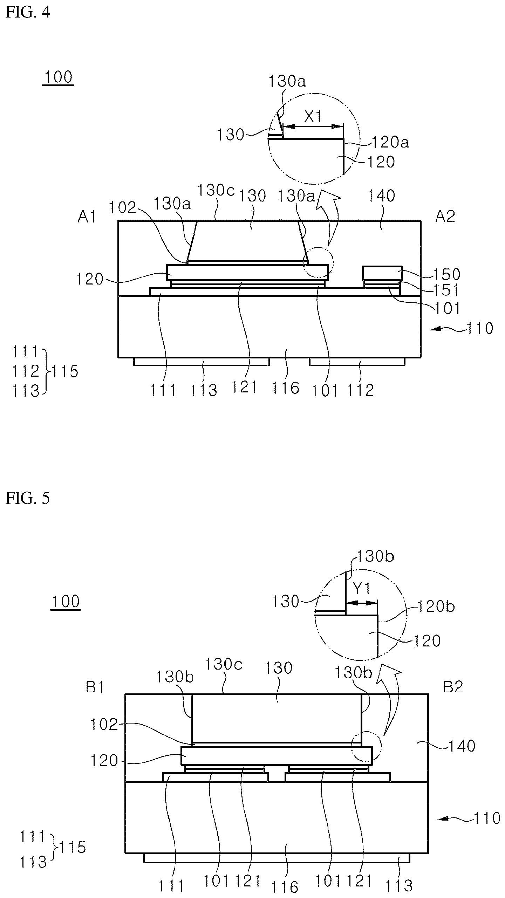

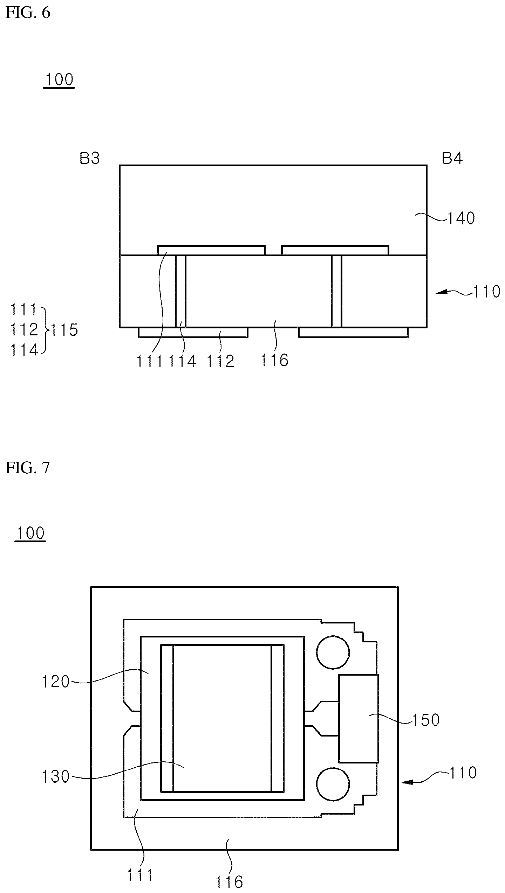

FIG. 2 is a perspective view of a light emitting device 100 according to a first embodiment. FIG. 3 is a bottom view of the light emitting device 100 according to the first embodiment. FIG. 4 is a cross-sectional view (A1-A2) of the light emitting device 100 according to the first embodiment. FIG. 5 is another cross-sectional view (B1-B2) of the light emitting device according to the first embodiment. FIG. 6 is a further cross-sectional view (B3-B4) of the light emitting device according to the first embodiment. In addition, FIG. 7 is a plan view of the light emitting device according to the first embodiment.

The light emitting device 100 according to the first embodiment may include a substrate 110, a light emitting part, a light transmitting member 130, and a barrier member 140. The light emitting part may generate and emit light. For example, the light emitting part may include at least one light emitting chip 120 including a light emitting diode.

The substrate 110 may include an electrically conductive pattern 115 and an insulating layer 116.

The insulating layer 116 may be formed of a general insulating material, such as an epoxy resin or prepreg, which is known in the field of printed circuit boards in the art.

Referring to FIG. 3 to FIG. 6, the electrically conductive pattern 115 may include a first circuit pattern 111, a second circuit pattern 112, a heat dissipation pattern 113, and a via 114.

The first circuit pattern 111 is formed on an upper surface of the insulating layer 116. The first circuit pattern 111 is electrically connected to the light emitting chip 120.

A first bonding member 101 having electrical conductivity may be interposed between the light emitting chip 120 and the first circuit pattern 111.

The first bonding member 101 may bond the light emitting chip 120 to the first circuit pattern 111. In addition, the first bonding member 101 may be formed of an electrically conductive material and may electrically connect an electrode pad 121 of the light emitting chip 120 to the first circuit pattern 111. That is, the light emitting chip 120 may be electrically connected to the substrate 110 by the first bonding member 101.

For example, the first bonding member 101 may be one among solder pastes including Sn and at least one of Pb, Cu, Ag, Au, Zn, Al, Bi, and In, Ag pastes, and Si pastes. Alternatively, the first bonding member 101 may be formed of any electrically conductive material capable of bonding the substrate 110 to the light emitting chip 120 without being limited to the above pastes.

The second circuit pattern 112 is formed on a lower surface of the insulating layer 116. The second circuit pattern 112 is electrically connected to an external component (not shown).

Referring to FIG. 6, the via 114 is formed to pass through the insulating layer 116. The via 114 may be formed by forming a through-hole in the insulating layer 116 and filling the through-hole with an electrically conductive material.

The via 114 may electrically connect the first circuit pattern 111 to the second circuit pattern 112. Alternatively, the via 114 may serve to transfer heat from the light emitting chip 120 to the second circuit pattern 112.

Referring to FIG. 3 and FIG. 4, the heat dissipation pattern 113 may be formed on the lower surface of the insulating layer 116. The heat dissipation pattern 113 may dissipate heat from the light emitting chip 120 to the outside of the light emitting device 100.

Referring to FIG. 4, the heat dissipation pattern 113 may be disposed below the light emitting chip 120. The heat dissipation pattern 113 disposed below the light emitting chip 120 is placed at the shortest distance from the light emitting chip 120. Accordingly, heat generated from the light emitting chip 120 can be rapidly transferred to the heat dissipation pattern 113.

In addition, as shown in FIG. 3, the heat dissipation pattern 113 may be formed widely over a remaining region excluding a region in which the second circuit pattern 112 is formed.

With this structure, since the heat dissipation pattern 113 has a large contact area with air, the heat dissipation pattern can allow rapid heat dissipation from the light emitting device 100.

The first circuit pattern 111, the second circuit pattern 112, the heat dissipation pattern 113 and the via 114 are formed of an electrically conductive material known in the field of substrates. For example, the first circuit pattern 111, the second circuit pattern 112 and the via 114 may be formed of copper (Cu).

The light emitting chip 120 is disposed on the substrate 110 and is electrically connected to the substrate 110. The light emitting chip 120 may be a light emitting diode chip. For example, light emitted from the light emitting chip 120 may be blue light.

The light emitting chip 120 may receive voltage or electric current through the substrate 110 to emit light. The light emitting chip 120 may have a thickness of about 110 µm to about 130 µm. Preferably, the light emitting chip 120 has a thickness of about 120 µm.

The light transmitting member 130 is placed on an upper surface of the light emitting chip 120. The light transmitting member 130 have a thickness of about 230 µm to about 320 µm, preferably about 250 µm to about 300 µm.

Light emitted from the light emitting chip 120 may be discharged outside the light emitting device 100 through the light transmitting member 130. That is, the light transmitting member 130 is a light emitting portion through which light emitted from the light emitting chip 120 is discharged, and an upper surface of the light transmitting member 130 becomes a light exit surface 130c through which light emitted from the light emitting device 100 is discharged.

According to an embodiment of the present invention, the light transmitting member 130 includes a pair of first side surfaces 130a facing each other and a pair of second side surfaces 130b facing each other.

The first side surfaces 130a and the second side surfaces 130b of the light transmitting member 130 may be inclined at different angles with respect to a lower surface of the light transmitting member 130. In addition, the first side surfaces 130a may be inclined at a smaller angle than the second side surfaces 130b.

For example, the pair of first side surfaces 130a may be formed to gradually approach each other from the upper surface of the light emitting chip 120 to a lower surface thereof. That is, the first side surfaces 130a may be inclined with respect to the upper surface of the light emitting chip 120.

In addition, the pair of second side surfaces 130b is parallel to each other. That is, the second side surfaces 130b are planar surfaces perpendicular to the upper surface of the light emitting chip 120.

Accordingly, the light transmitting member 130 has a cross-sectional area gradually decreasing from the lower surface to the upper surface thereof.

Referring to FIG. 2, the light transmitting member 130 is placed in an upper surface region of the light emitting chip 120. That is, the lower surface of the light transmitting member 130 has a smaller area than the upper surface of the light emitting chip 120.

The light transmitting member 130 is formed of a light transmissive material. For example, the light transmitting member 130 may be formed of at least one selected from among a transparent resin, glass, and ceramics. The transparent resin may be an epoxy resin, a silicone resin, or the like.

The light transmitting member 130 may further include a wavelength conversion material dispersed in the transparent resin, the glass, and the ceramics.

A second bonding member 102 may further formed between the light emitting chip 120 and the light transmitting member 130.

The second bonding member 102 may be formed of a material allowing transmission of light therethrough and bonding the light emitting chip 120 to the light transmitting member 130.

The wavelength conversion material may convert the wavelength of light emitted from the light emitting chip 120. For example, the light emitting device 100 may emit white light or a particular color through the wavelength conversion material.

For example, the wavelength conversion material may include phosphors. The phosphors may include a yellow phosphor, a red phosphor, a green phosphor, and the like.

According to this embodiment, a first distance X1 between the light transmitting member 130 and the light emitting chip 120 may be greater than a second distance Y1.

Referring to FIG. 4, the first distance X1 refers to a straight distance from a lower end of each of the first side surfaces 130a of the light transmitting member 130 to a first side surface 120a of the light emitting chip 120. The first side surface 120a of the light emitting chip 120 is a side surface disposed closest and parallel to the lower end of the first side surface 130a of the light transmitting member 130. In addition, the first side surface 120a of the light emitting chip 120 may be one side surface of a growth substrate constituting the light emitting chip 120. Here, the growth substrate may be a substrate for growth of a light emitting structure including an n-type semiconductor layer, an active layer and a p-type semiconductor layer of the light emitting chip 120.

According to this embodiment, the light emitting chip 120 may be divided into a light generating part and a light emitting part. The light generating part of the light emitting chip 120 may generate light upon receiving voltage or electric current from the substrate 110. For example, the light generating part of the light emitting chip 120 may be a light emitting structure including an n-type semiconductor layer, an active layer and a p-type semiconductor layer. In addition, the light emitting part of the light emitting chip 120 is placed on the light generating part and emits light generated in the light generating part to the outside of the light emitting chip 120. For example, the light emitting part of the light emitting chip 120 may be a growth substrate composed of sapphire (Al₂O₃).

Referring to FIG. 5, the second distance Y1 may be a straight distance from a lower end of each of the second side surfaces 130b of the light transmitting member 130 to a second side surface 120b of the light emitting chip 120. The second side surface 120b of the light emitting chip 120 is a side surface disposed closest and parallel to the lower end of the second side surface 130b of the light transmitting member 130 and may be the other side surface of the growth substrate of the light emitting chip 120.

The barrier member 140 may be formed on an upper surface of the substrate 110 to cover the light emitting chip 120 and the side surfaces of the light transmitting member 130. Accordingly, the barrier member 140 may be formed to surround the light emitting chip 120 and the light transmitting member 130 excluding the light exit surface of the light transmitting member 130 corresponding to the upper surface thereof.

With this structure, the barrier member 140 may protect the light emitting chip 120 and the light transmitting member 130 from an external environment. In addition, the barrier member 140 allows light emitted from the light emitting chip 120 to be discharged only through the light exit surface.

According to this embodiment, since the lower surface of the light transmitting member 130 has a smaller area than the upper surface of the light emitting chip 120, the light transmitting member 130 does not cover the entire upper surface of the light emitting chip 120. Accordingly, when the light transmitting member 130 is formed on the upper surface of the light emitting chip 120, a portion of the upper surface of the light emitting chip 120 is exposed outside.

When the barrier member 140 is formed to cover the light emitting chip 120 and the light transmitting member 130, the barrier member 140 covers the exposed portion of the upper surface of the light emitting chip 120.

For example, the barrier member 140 may be formed of a silicone resin. Alternatively, the barrier member 140 may be formed of a reflective material-containing silicone resin. For example, the reflective material may be TiO₂.

In addition, an outer surface of the barrier member 140 may be placed collinear with an outer surface of the substrate 110.

In the light emitting device 100 according to this embodiment, with multiple light emitting chips 120 disposed on the substrate 110, the light transmitting member 130 and the barrier member 140 may be formed thereon. After the barrier member 140 is formed, the light emitting device 100 may be formed into individual light emitting devices through a dicing process.

Since the light emitting device 100 according to this embodiment is formed through such a process, the outer surface of the barrier member 140 may be placed collinear with the outer surface of the substrate 110.

According to this embodiment, the light emitting device 100 may include a Zener diode 150.

Referring to FIG. 4 and FIG. 7, the Zener diode 150 may be disposed on the substrate 110 to be electrically connected to the electrically conductive pattern 115.

The Zener diode 150 may be electrically connected to the first bonding member 101 interposed between an electrode 151 and the first circuit pattern 111 by the first circuit pattern 111.

The Zener diode 150 may be connected in parallel to the light emitting chip 120 through the electrically conductive pattern 115. However, it should be understood that connection between the Zener diode 150 and the light emitting chip 120 is not limited thereto. By changing the structure of the electrically conductive pattern 115, the Zener diode 150 may be connected in series to the light emitting chip 120.

Alternatively, the light emitting device 100 may omit the Zener diode 150.

In the light emitting device 100 according to this embodiment, the light exit surface through which light is discharged has a smaller area than the upper surface of the light emitting chip 120. The area of the light exit surface of the light transmitting member 130 may vary depending upon inclination of the pair of first side surfaces 130a. For example, the first side surfaces 130a of the light transmitting member 130 may be inclined at about 76° with respect to the lower surface thereof.

Accordingly, light emitted from the light emitting chip 120 is concentrated on the light exit surface having a smaller area than the upper surface of the light emitting chip 120, thereby increasing a traveling length of light.

Further, in the light emitting device 100 according to this embodiment, the side surfaces of light transmitting member 130 are composed of flat surfaces inclined with respect to the lower surface thereof and flat surfaces perpendicular to the lower surface thereof.

That is, since all side surfaces of the light transmitting member 130 are composed of flat surfaces, the light transmitting member 130 allows easy machining.

Hereinafter, in description of other embodiments, description of the same components as those of the light emitting device 100 according to the first embodiment will be omitted or given briefly. Despite different reference numerals, the following description of components with the same terms will focus on different features of other embodiments and description of the same parts will be given briefly or omitted. For omitted or brief description, refer to the detailed description of other embodiments.

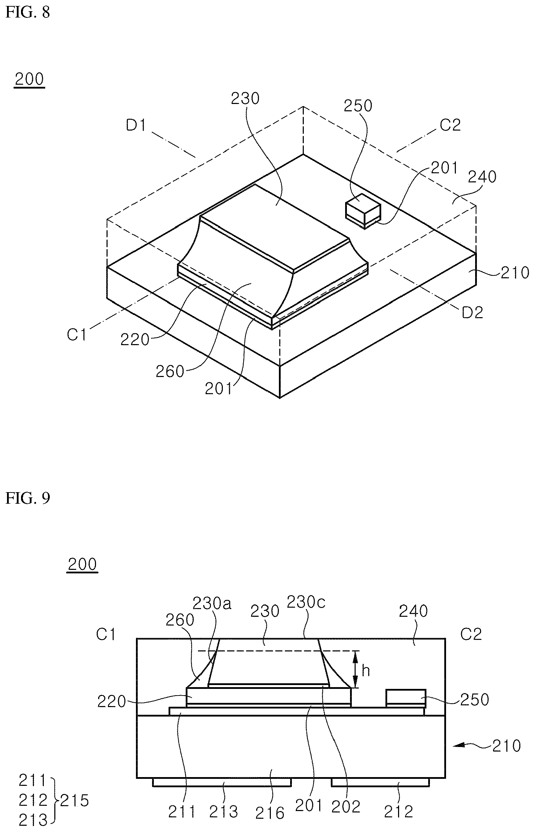

FIG. 8 to FIG. 10 are exemplary views of a light emitting device according to a second embodiment of the present invention.

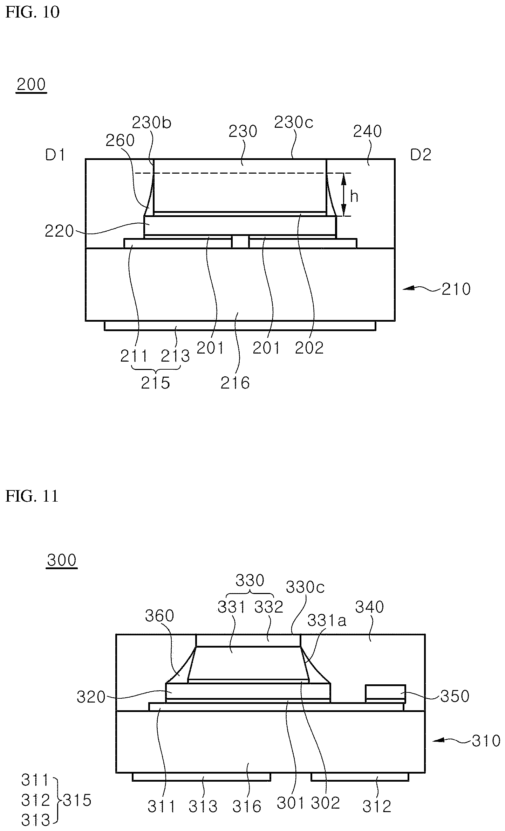

FIG. 8 is a perspective view of a light emitting device 200 according to the second embodiment. FIG. 9 is a cross-sectional view (C1-C2) of the light emitting device 200 according to the second embodiment. FIG. 10 is another cross-sectional view (D1-D2) of the light emitting device 200 according to the second embodiment.

The light emitting device 200 according to the second embodiment may include a substrate 210, a light emitting chip 220, a light transmitting member 230, a barrier member 240, a reflective member 260, a first bonding member 201, and a second bonding member 202.

The substrate 210 may include an insulating layer 216 and an electrically conductive pattern 215 formed on the insulating layer 216. The electrically conductive pattern 215 may include a first circuit pattern 211 formed on the upper surface of the insulating layer 216 and electrically connected to the light emitting chip 220. In addition, the electrically conductive pattern 215 may include a second circuit pattern 212 and a heat dissipation pattern 213 formed on the lower surface of the insulating layer 216. Further, the electrically conductive pattern 215 may include a via (not shown) formed in the insulating layer 216 and electrically connecting the first circuit pattern 211 to the second circuit pattern 212.

The first bonding member 201 is formed between the substrate 210 and the light emitting chip 220 and the second bonding member 202 is formed between the light emitting chip 220 and the light transmitting member 230. The first bonding member 201 may be electrically connected to the light emitting chip 220 through contact with electrodes (not shown) thereof.

The light transmitting member 230 becomes a light exit surface 230c exposed outside the light emitting device 200 such that light emitted from the light emitting device is discharged therethrough. In addition, the light transmitting member 230 may include a pair of first side surfaces 230a and a pair of second side surfaces 230b. Here, the first side surfaces 230a of the light transmitting member 230 may be inclined at a smaller angler than the second side surfaces 230b with respect to a lower surface thereof.

The light emitting device 200 may also include a Zener diode 250.

The reflective member 260 may be formed on an upper surface of the light emitting chip 220 and may cover the side surfaces of the light transmitting member 230. That is, the reflective member 260 may be formed to cover a portion of the upper surface of the light emitting chip 220 and a portion of the side surfaces of the light transmitting member 230.

In addition, a lower end of a side surface of the reflective member 260 may be coincident with an upper end of a side surface of the light emitting chip 220. Alternatively, the lower end of the reflective member 260 may cover a portion of the side surface of the light emitting chip 220.

The reflective member 260 may be formed of a resin. Alternatively, the reflective member 260 may further include a reflective material in the resin.

For example, the resin may be an epoxy resin, a silicone resin, a phenol resin, a polycarbonate resin, an acrylic resin, a TPX resin, a polynorbornene resin or a modification thereof, or a hybrid resin comprising two or more of these resins.

For example, the reflective material may be TiO₂.

According to this embodiment, the reflective member 260 may have a different index of refraction than the light transmitting member 230. For example, the index of refraction of the reflective member 260 may be adjusted according to the reflective material dispersed in the resin.

Such a reflective member 260 may prevent light emitted through the upper surface of the light emitting chip 220 and traveling towards the barrier member 240 from being absorbed by the barrier member 240. In addition, the reflective member 260 may reflect emitted through the side surfaces of the light transmitting member 230 towards the light transmitting member 230.

Although the reflective member 260 is distinguished from the second bonding member 202 in this embodiment, the reflective member 260 and the second bonding member 202 may be formed of the same material.

Referring to FIG. 9 and FIG. 10, the reflective member 260 has a thickness gradually increasing from an upper portion thereof to a lower portion thereof. In addition, the reflective member 260 may have a downwardly concave side surface.

Light emitted outside the light transmitting member 230 may be reflected towards a light exit surface 230c of the light transmitting member 130 by the concave surface of the reflective member 260. Here, the light emitted outside the light transmitting member 230 is light emitted through the upper surface of the light emitting chip 220 exposed by the light transmitting member 230.

As such, the reflective member 260 may prevent light, which is emitted from the light emitting chip 220 and travels towards the barrier member 240, from being absorbed by the barrier member 240, and may improve luminous efficacy of the light emitting device 200 by reflecting the light towards the light exit surface 230c.

A height h of the reflective member 260 may be two-thirds of a height of the light transmitting member 230. That is, an upper end of the reflective member 260 may be placed at a point two-thirds of the height of the light transmitting member 230. Here, the height of the light transmitting member 230 is a length from the lower surface of the light transmitting member 230 to the upper surface thereof.

With such a structure, the light emitting device 200 according to this embodiment may improve straightness of light by focusing light on the light exit surface 230c having a smaller area than the upper surface of the light emitting chip 220. In addition, the light emitting device 200 according to this embodiment includes the reflective member 260, which reflects light towards the light exit surface 230c instead of allowing the light to travel towards the barrier member 240, thereby improving light extraction efficiency. That is, the light emitting device 200 according to this embodiment may improve light extraction efficiency and straightness of light at the same time.

FIG. 11 is an exemplary view of a light emitting device according to a third embodiment of the present invention.

The light emitting device 300 according to the third embodiment may include a substrate 310, a light emitting chip 320, a light transmitting member 330, a barrier member 340, a reflective member 360, a first bonding member 301, and a second bonding member 303. The first bonding member 301 may be electrically connected to the light emitting chip 320 through contact with electrodes (not shown) of the light emitting chip 320.

The substrate 310 may include an insulating layer 316 and an electrically conductive pattern 315 formed on the insulating layer 316. The electrically conductive pattern 315 may include a first circuit pattern 311 formed on an upper surface of the insulating layer 316 and electrically connected to the light emitting chip 320. In addition, the electrically conductive pattern 315 may include a second circuit pattern 312 and a heat dissipation pattern 313 formed on a lower surface of the insulating layer 316. Further, the electrically conductive pattern 315 may include a via (not shown) formed in the insulating layer 316 and electrically connecting the first circuit pattern 311 to the second circuit pattern 312.

The first bonding member 301 is formed between the substrate 310 and the light emitting chip 320 and the second bonding member 303 is formed between the light emitting chip 320 and the light transmitting member 330.

In addition, the light emitting device 300 may also include a Zener diode 350.

Referring to FIG. 11, the light transmitting member 330 may include multiple layers.

For example, the light transmitting member 330 may include a wavelength conversion layer 331 and a protective layer 332.

Both the wavelength conversion layer 331 and the protective layer 332 may be formed of a light transmissive material.

The wavelength conversion layer 331 is placed on the upper surface of the light emitting chip 120 and may contain a wavelength conversion material dispersed in the light transmissive material. For example, the light transmissive material may be glass, ceramics or a transparent material.

The wavelength conversion layer 331 may include a pair of first side surfaces 331a and a pair of second side surfaces (not shown). Here, the first side surfaces 331a of the wavelength conversion layer 331 may be inclined at a smaller angler with respect to a lower surface thereof than the second side surfaces (not shown) thereof.

The protective layer 332 may be placed on an upper surface of the wavelength conversion layer 331 and may be formed of glass or ceramics. The wavelength conversion layer 331 may include the wavelength conversion material, whereas the protective layer 332 may not include the wavelength conversion material.

The protective layer 332 may cover the wavelength conversion layer 331 to protect the wavelength conversion layer 331 from an external environment.

According to this embodiment, an upper surface of the protective layer 332 is exposed to the outside of the light emitting device 300 and constitutes a light exit surface 330c through which light generated in the light emitting device 300 is emitted.

The structure and material of the reflective member 360 of the light emitting device 300 according to the third embodiment are the same as those of the reflective member 260 of the light emitting device of the light emitting device according to the second embodiment (see FIG. 8 to FIG. 10).

The reflective member 360 may cover the upper surface of the light emitting chip 320 and some side surfaces of the wavelength conversion layer 331. The reflective member 360 may have a different index of refraction than the light transmitting member 230.

For example, the reflective member 360 may be formed of a silicone resin. Alternatively, the reflective member 260 may further include a reflective material dispersed in the silicone resin. Here, the reflective material may be TiO₂. The index of refraction of the reflective member 360 may vary depending upon the reflective material.

The barrier member 340 may be formed to cover a portion of the wavelength conversion layer 331 and the side surfaces of the protective layer 332 exposed by the reflective member 360. The upper surface of the protective layer 332 may be coplanar with an upper surface of the barrier member 340.

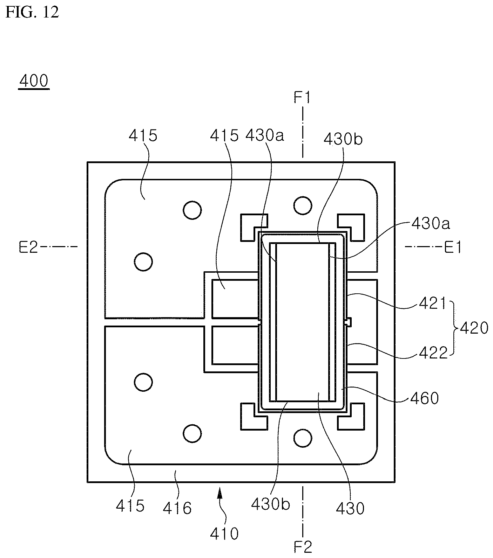

FIG. 12 to FIG. 14 are exemplary embodiments of a light emitting device according to a fourth embodiment of the present invention.

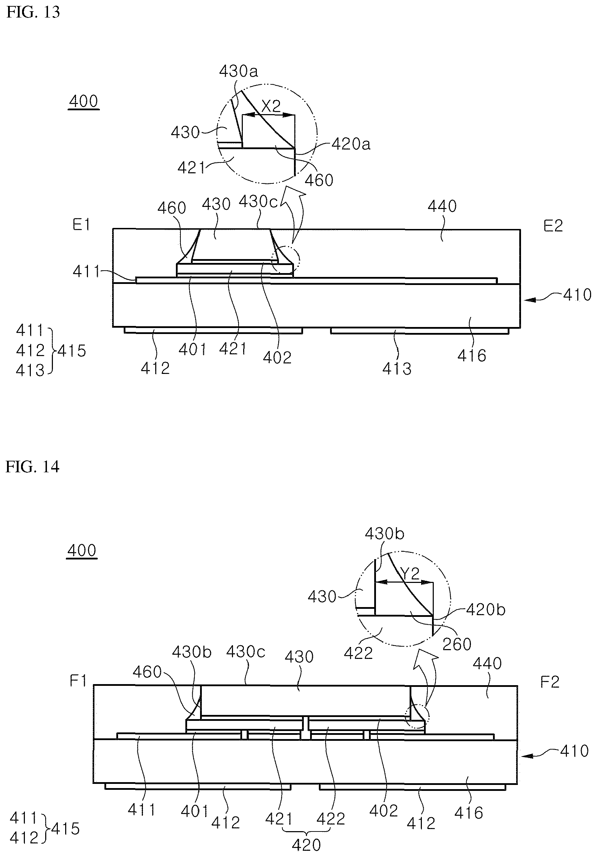

FIG. 12 is a plan view of a light emitting device 400 according to the fourth embodiment. In FIG. 12, a barrier member 440 of the light emitting device 400 is omitted. FIG. 13 is a cross-sectional view (E1-E2) of the light emitting device 400 according to the fourth embodiment. In addition, FIG. 14 is another cross-sectional view (F1-F2) of the light emitting device 400 according to the fourth embodiment.

The light emitting device 400 according to the fourth embodiment may include a substrate 410, a light emitting part 420, a light transmitting member 430, a barrier member 440, a reflective member 460, a first bonding member 401, and a second bonding member 402. The first bonding member 401 may be electrically connected to the light emitting chip 420 through contact with electrodes (not shown) thereof.

The substrate 410 may include an insulating layer 416 and an electrically conductive pattern 415 formed on the insulating layer 416. The electrically conductive pattern 415 may include a first circuit pattern 411 formed on an upper surface of the insulating layer 416 and electrically connected to the light emitting chip 420. In addition, the electrically conductive pattern 415 may include a second circuit pattern 412 and a heat dissipation pattern 413 formed on a lower surface of the insulating layer 416. Further, the electrically conductive pattern 415 may include a via (not shown) formed in the insulating layer 416 and electrically connecting the first circuit pattern 411 to the second circuit pattern 412.

The first bonding member 401 is formed between the substrate 410 and the light emitting chip 420 and the second bonding member 402 is formed between the light emitting chip 420 and the light transmitting member 430.

The light transmitting member 430 becomes a light exit surface 430c exposed outside the light emitting device 400 such that light emitted from the light emitting device is discharged therethrough. In addition, the light transmitting member 430 may include a pair of first side surfaces 430a and a pair of second side surfaces 430b. Here, the first side surfaces 430a of the light transmitting member 430 may be inclined at a smaller angler than the second side surfaces 430b thereof with respect to a lower surface thereof.

Although FIG. 12 to FIG. 14 do not show a Zener diode, the light emitting device 400 according to this embodiment may include a Zener diode.

The light emitting part 420 may include multiple light emitting chips.

According to this embodiment, the light emitting part 420 may include a first light emitting chip 421 and a second light emitting chip 422.

Both the first light emitting chip 421 and the second light emitting chip 422 may be disposed on the substrate 410 and may be electrically connected to the electrically conductive pattern 415. Here, the electrically conductive pattern 415 is a circuit pattern electrically connected to at least one of the first light emitting chip 421 and the second light emitting chip 422.

Referring to FIG. 12, the first light emitting chip 421 and the second light emitting chip 422 may be connected to each other in series by the electrically conductive pattern 415. However, it should be understood that a connection structure between the first light emitting chip 421 and the second light emitting chip 422 is not limited thereto. The light emitting device 400 may include the first light emitting chip 421 and the second light emitting chip 422 connected to each other in parallel.

The light transmitting member 430 is formed to cover an upper surface of the light emitting part 420.

A lower surface of the light transmitting member 430 has a smaller area than the upper surface of the light emitting part 420. Here, the upper surface of the light emitting part 420 may correspond to an upper surface of the first light emitting chip 421 and an upper surface of the second light emitting chip 422. Alternatively, the upper surface of the light emitting part 420 may include the upper surface of the first light emitting chip 421, the upper surface of the second light emitting chip 422 and a region between the first light emitting chip 421 and the second light emitting chip 422.

In this embodiment, the light transmitting member 430 includes a pair of first side surfaces 430a, which are inclined surfaces, and a pair of second side surfaces 430b perpendicular to the lower surface thereof.

Here, the light transmitting member 430 may have a structure wherein the pair of first side surfaces 430a gradually approaches each other from the lower surface to the upper surface thereof such that the light transmitting member 430 has a cross-sectional area gradually decreasing from the lower surface to the upper surface thereof.

The first side surfaces 430a of the light transmitting member 430 may have a greater length than the second side surfaces 430b thereof.

Referring to FIG. 12 and FIG. 13, the pair of first side surfaces 430a of the light transmitting member 430 is disposed parallel to a longitudinal direction of the light emitting part 420. That is, the light transmitting member 430 is elongated such that the pair of first side surfaces 430a spans the upper surface of the first light emitting chip 421 and the upper surface of the second light emitting chip 422, which are disposed side by side.

Referring to FIG. 12 and FIG. 14, one of the pair of second side surfaces 430b of the light transmitting member 430 is disposed parallel to the side surfaces of the first light emitting chip 421 on the upper surface of the first light emitting chip 421. In addition, the other second side surface of the light transmitting member 430 is disposed parallel to the side surfaces of the second light emitting chip 422 on the upper surface of the second light emitting chip 422.

The upper surface of the first light emitting chip 421 and the upper surface of the second light emitting chip 422 may be partially exposed outside the light transmitting member 430. The portions of the first light emitting chip 421 and the second light emitting chip 422 exposed by the light transmitting member 430 may be covered by the barrier member 140. Further, the barrier member 440 may be placed between the first light emitting chip 421 and the second light emitting chip 422.

Light emitted from the first light emitting chip 421 and light emitted from the second light emitting chip 422 may be discharged from the light emitting device 400 through the light transmitting member 430.

In the light emitting device 400 according to this embodiment, a first distance X2 may be the same as or slightly greater than a second distance Y2.

Here, the first distance X2 may be a straight distance from a lower end of the first side surfaces 430a of the light transmitting member 430 to an upper end of first side surfaces 420a of the first light emitting chip 421 or the second light emitting chip 422.

In addition, the second distance Y2 may be a straight distance from a lower end of the second side surface 430b of the light transmitting member 430 to an upper end of the second side surface 430b of the first light emitting chip 421 or the second light emitting chip 422.

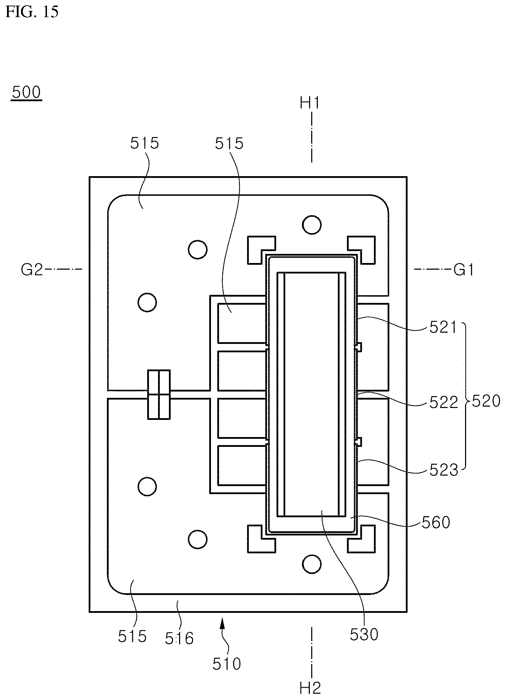

FIG. 15 to FIG. 17 are exemplary views of a light emitting device according to a fifth embodiment of the present invention.

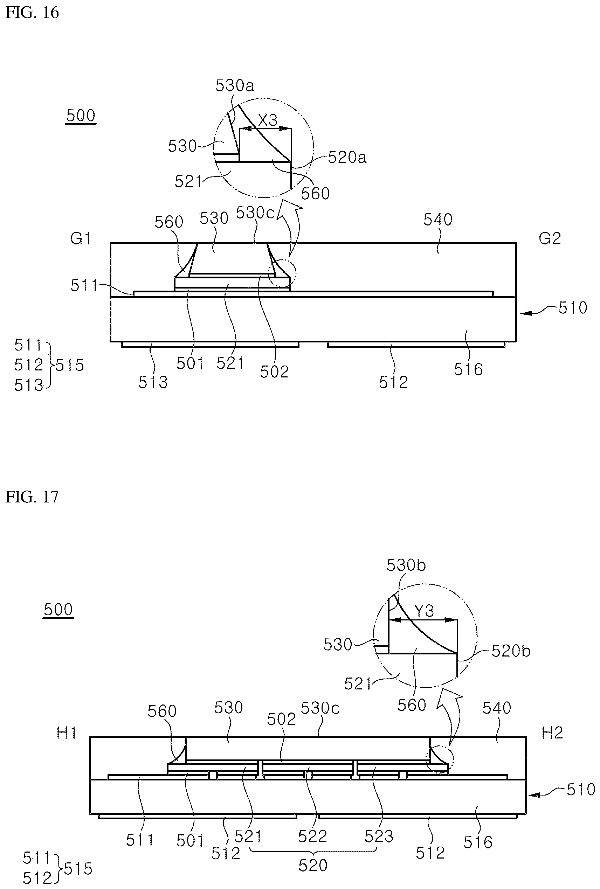

FIG. 15 is a plan view of the light emitting device 500 according to the fifth embodiment. In FIG. 15, the barrier member 140 of light emitting device 500 is omitted. FIG. 16 is a cross-sectional view (G1-G2) of the light emitting device 500 according to the fifth embodiment. In addition, FIG. 17 is another cross-sectional view of (H1-H2) of the light emitting device 500 according to the fifth embodiment.

The light emitting device 500 according to the fifth embodiment may include a substrate 510, a light emitting part 520, a light transmitting member 530, a barrier member 540, a reflective member 560, a first bonding member 501, and a second bonding member 502. The first bonding member 501 may be electrically connected to the light emitting part 520 through contact with electrodes (not shown) thereof.

The substrate 510 may include an insulating layer 516 and an electrically conductive pattern 515 formed on the insulating layer 516. The electrically conductive pattern 515 may include a first circuit pattern 511 formed on an upper surface of the insulating layer 516 and electrically connected to the light emitting part 520. In addition, the electrically conductive pattern 515 may include a second circuit pattern 512 and a heat dissipation pattern 513 formed on a lower surface of the insulating layer 516. Further, the electrically conductive pattern 515 may include a via (not shown) formed in the insulating layer 516 and electrically connecting the first circuit pattern 511 to the second circuit pattern 512.

The first bonding member 501 is formed between the substrate 510 and the light emitting chip 520 and the second bonding member 502 is formed between the light emitting chip 520 and the light transmitting member 530.

The light transmitting member 530 becomes a light exit surface 530c exposed outside the light emitting device 500. In addition, the light transmitting member 530 may include a pair of first side surfaces 530a and a pair of second side surfaces 530b. Here, the first side surfaces 530a of the light transmitting member 530 may be inclined at a smaller angler with respect to a lower surface thereof than the second side surfaces 530b thereof.

The light emitting part 520 may include multiple light emitting chips.

According to this embodiment, the light emitting part 520 may include a first light emitting chip 521, a second light emitting chip 522, and a third light emitting chip 523.

Referring to FIG. 15, the first to third light emitting chips 521 to 523 are linearly arranged in one direction.

Each of the first to third light emitting chips 521 to 523 may include a pair of first side surfaces 520a and a pair of second side surfaces 520b.

The first side surfaces 520a of each of the first to third light emitting chips 521 to 523 are parallel to lower ends of the first side surfaces 530a of the light transmitting member 530 and the second side surfaces 520b thereof are parallel to lower ends of the second side surfaces 530b of the light transmitting member 530.

The first to third light emitting chips 521 to 523 arranged side by side may be electrically connected to each other by the electrically conductive pattern 515, which is a circuit pattern on the substrate 510.

Although FIG. 15 shows the first to third light emitting chips 521 to 523 connected to each other in series, it should be understood that the first to third light emitting chips 521 to 523 may be connected to each other in parallel according to the structure of the electrically conductive pattern 515.

The light transmitting member 530 is formed to cover the upper surface of the light emitting part 520.

Here, the upper surface of the light emitting part 520 may correspond to upper surfaces of the first to third light emitting chips 521 to 523. Alternatively, the upper surface of the light emitting part 520 may include the upper surfaces of the first to third light emitting chips 521 to 523 and a region between the upper surfaces thereof.

The light transmitting member 530 may be elongated to simultaneously cover the upper surfaces of the first to third light emitting chips 521 to 523 arranged side by side.

In the light emitting device 500 according to this embodiment, a first distance X3 may be smaller than a second distance Y3. Here, the first distance X3 may be a straight distance from a lower end of the first side surface 530a of the light transmitting member 530 to an upper end of the first side surface 520a of each of the first to third light emitting chips 521 to 523. In addition, the second distance Y2 may be a straight distance from a lower end of the second side surface 530b of the light transmitting member 530 to an upper end of the second side surface 520b of the first light emitting chip 521 or the third light emitting chip 523.

The light emitting device 100 according to the first embodiment includes a single light emitting chip, the light emitting device 400 according to the fourth embodiment includes two light emitting chips, and the light emitting device 500 according to the fifth embodiment includes three light emitting chips.

Here, in the light emitting device, the distance between the lower end of the side surface of the light transmitting member and the side surface of the light emitting chip varies with increasing number of light emitting chips.

For example, as the number of light emitting chips increases, the second distance, that is, the distance between the lower end of the second side surfaces of the light transmitting member and the second side surfaces of the light emitting chip, may increase.

The light emitting devices according to the embodiments of the present invention may be applied to vehicular headlamps. Straightness of light is important for the headlamps to ensure visibility of a driver for a long distance. The light emitting devices according to the embodiments of the present invention include the light transmitting member that has a smaller cross-sectional area than the upper surface of the light emitting part including at least one light emitting chip. In addition, the light emitting devices according to the embodiments of the invention are formed to have a pair of side surfaces having an inclination, thereby decreasing the area of the light exit surface through which light emitted from the light emitting device is discharged. Further, the light emitting devices according to the embodiments of the invention include the light transmitting member having a pair of side surfaces inclined at an angle of about 75° and a reflective member covering the side surfaces of the light transmitting member, thereby improving straightness of light while minimizing light loss, despite decrease in area of the light emitting surface thereof.

A vehicular headlamp including the light emitting device according to the embodiments of the invention improves straightness of light while minimizing light loss, thereby allowing drives to see farther.

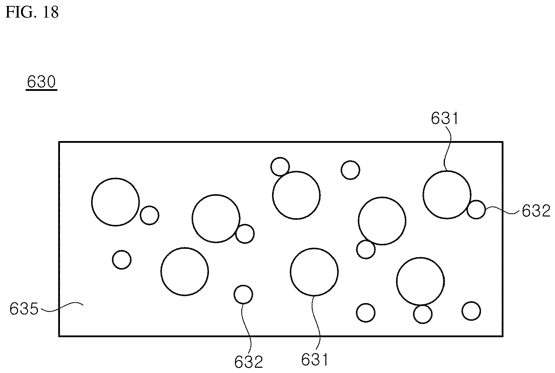

FIG. 18 is an exemplary view of a light transmitting member according to one embodiment of the present invention.

Referring to FIG. 18, the light transmitting member 630 according to this embodiment may include a support member 635, first particles 631, and second particles 632. The support member 635 may be a ceramic member formed of a ceramic material. In addition, the support member 635 may be formed of the same material as the growth substrate of the light emitting chip 120 or may include the same element as the growth substrate. The first particles may be a phosphor, which is a luminous material. In addition, the second particles 632 may be a non-luminous material that does not emit light. The first particles 631 and the second particles 632 may be dispersed in the support member 635.

According to the embodiment of the invention, the support member 635 may be formed of aluminum oxide (Al₂O₃), which is an oxide ceramic. That is, the support member 635 may have the same index of refraction as the growth substrate. In addition, a material having a different index of refraction than the support member may be disposed between the support member 635 and the growth substrate, which have the same index of refraction. For example, the material having the different index of refraction may be air. In addition, the material having the different index of refraction may be a bonding material, such as silicone, which connects the support member 635 to the growth substrate. As such, the material having the different index of refraction is formed between the support member and the growth substrate, thereby improving luminous efficiency by preventing total reflection, by which light reenters the light emitting chip corresponding to the light generating part.

To form the light transmitting member 630, a powder mixture may be prepared by mixing aluminum oxide powder with powder of the luminous material as the first particles 631 and powder of the non-luminous material as the second particles 632. Here, the powder of the non-luminous material is composed of at least one of barium fluoride and silicon dioxide. That is, the second particles 632 may include at least one of barium fluoride and silicon dioxide.

Next, a molded product may be prepared by press molding of the powder mixture.

Then, the molded product is sintered at high temperature to form the light transmitting member 630, which is a sintered product.

According to the embodiment, when at least one of barium fluoride (BaF₂) and silicon dioxide (SiO₂) is added as the second particles 632 to the powder mixture, porosity of the light transmitting member 630 may be decreased. Decrease in porosity may reduce light scattering caused by pores. In addition, decrease in porosity may improve purity of the support member 635. Further, light transmittance of the support member 635 may also be improved through decrease in porosity and improvement in purity. Accordingly, the light transmitting member 630 according to this embodiment may improve luminous efficacy.

Further, the second particles 632 may reduce a sintering temperature for sintering the molded product. Accordingly, the second particles 632 may minimize change in characteristics of the phosphor due to a great temperature difference by reducing the difference between the sintering temperature and a cooling temperature. Accordingly, the second particles 632 can prevent deterioration in luminous efficacy due to change in characteristics of the phosphor by reducing the temperature difference in the process of forming the light transmitting member 630.

Through this process, the light transmitting member 630 in which the first particles 631 as the luminous material and the second particles 632 as the non-luminous material are dispersed, may be formed.

Although the support member 635 having the first particles 631 and the second particles 632 dispersed therein is illustrated by way of example as being formed of aluminum oxide in this embodiment, it should be understood that the kind of support member 635 is not limited thereto. The support member 635 of the light transmitting member 630 may have the first particles 631 and the second particles 632 dispersed therein and may be formed of any material that transmits light emitted from the first particles 631 and light emitted from the light emitting chip.

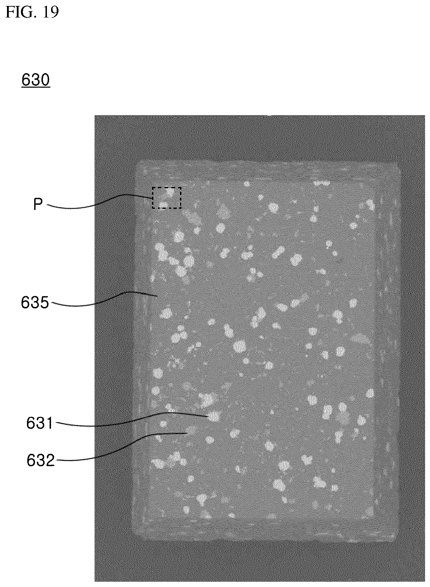

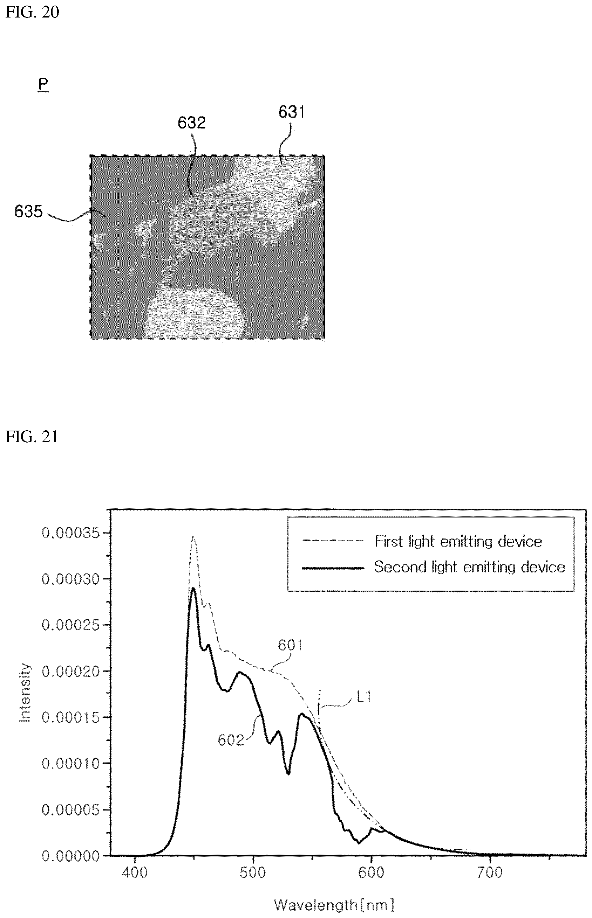

FIG. 19 and FIG. 20 are images of a cross-section of the light transmitting member according to the embodiment of the present invention.

FIG. 19 is an SEM (Scanning Electron Microscope) image of a cross-section of the light transmitting member 630. In addition, FIG. 20 is an enlarged SEM image of a portion P of the light transmitting member 630.

Referring to FIG. 19, it can be seen that the first particles 631 as the luminous material and the second particles 632 as the non-luminous material are dispersed in the support member 635 formed of aluminum oxide. At least some of the first particles 631 and the second particles 632 dispersed in the support member 635 may be joined to each other. Referring to FIG. 20, it can be seen that some of the first particles 631 contact some of the second particles 632 to form a structure wherein the first particles 631 are joined to the second particles 632. Since the first particles 631 are joined to the second particles 632, the surfaces of the particles are not completely exposed. Since the surfaces of the first particles 631 are partially covered by the second particles 632, it is possible to effectively prevent the first particles 631 from being exposed to external moisture or heat.

Referring to FIG. 20, the first particles 631 corresponding to the luminous material are brighter than the second particles 632 and have curved corners. In addition, the second particles 632 corresponding to the non-luminous material are darker than the first particles 631 and have angled corners. Since the particles having different shapes are dispersed in the light transmitting member 630, the particles generate light scattering inside the support member 635, thereby enabling uniform distribution of light. However, it should be understood that the present invention is not limited thereto and the first particles 631 and the second particles 632 may have an amorphous shape depending upon a coupling shape.

According to the embodiment of the invention, the first particles 631 are the phosphor and may include at least one selected from among a green phosphor, a yellow phosphor, a red phosphor, and a cyan phosphor.

For example, the phosphor may be a garnet phosphor represented by (A, B, C)₈₋ₓO₁₂:Ce. Here, A may include at least one element selected from among Y, Lu, Tb, Gd, La, and Sm. C may include at least one selected from among Al, Si, Ga, and In. B may be one of the A or B elements. Alternatively, B may be the same element as the A or B elements. Here, when B is one of the elements of C, the total moles of B and C may be greater than 5 and less than 7. In addition, when B is one of the elements of A, the total moles of A and B may be greater than 1 and less than 5. In addition, X may be greater than 0.001 and equal to or less than 0.5.

The phosphor may include at least one selected from among garnet phosphors, silicate phosphors, sulfide phosphors, oxynitride phosphors, nitride phosphors, and aluminate phosphors.

For example, the garnet phosphors may be represented by A₃B₅O₁₂:C. Here, A may include at least one element selected from among Y, Lu, Tb, and Gd. B may include at least one element selected from among Al, Ga, Si, and In. In addition, C may include at least one element selected from among Ce, Nd, Er, and Th. For example, the garnet phosphors may include a green phosphor of Y₃Al₅O₁₂:Ce(YAG:Ce), a yellow phosphor of Tb₃Al₅O₁₂:Ce(TAG:Ce), a green phosphor of Lu₃Al₅O₁₂:Ce, and the like. Here, when some Y elements of the YAG phosphor are substituted with Gd, the peak wavelengths of the YAG phosphor are shifted to a red wavelength band to emit red light. In addition, when some A elements thereof are substituted with Ga, the peak wavelengths of the YAG phosphor are shifted to a green wavelength band to emit green light. As such, colors emitted from the phosphor may be adjusted through adjustment of the composition ratio of the elements thereof.

In addition, the silicate phosphors may include a green or yellow phosphor of (Ba, Sr, Ca)₂SiO₄:Eu, a green or yellow phosphor of (Sr, Ba, Ca, Mg, Zn)₂Si(OD)₄:Eu (where D is at least one selected from among F, Cl, S, N, and Br), a green phosphor of Ba₂MgSi₃O₇:Eu, a green phosphor of Ba₂SiO₄:Eu, a green phosphor of Ca₃(Sc,Mg)₂Si₃O₁₂:Ce, a green phosphor of Ca₈Mg(SiO₄)₄Cl₂:Eu, and the like.

Further, the sulfide phosphors may include a red phosphor of (Ca,Sr)S:Eu, a green phosphor of (Sr,Ca)Ga₂S₄:Eu, a green phosphor of SrSi₂O₂N₂:Eu, and the like.

Further, the oxynitride phosphors may include a blue or green phosphor of SiAlON:Ce, a green or yellow phosphor of βu (for example, Si_{6-z}Al_{z}O_{z}N_{8-z}:Eu (0<z<4.2)), an orange or yellow phosphor of α-SiAlON:Eu (for example, M_{z}(Si, Al)₁₂(O, N)₁₆, 0<z≤2, M is Li, Mg, Ca, Y, and a lanthanum group element excluding La and Ce), a green phosphor of Ba₃Si₆O₁₂N₂:Eu, and the like.

Further, the nitride phosphors may include a red phosphor of CaAlSiN₃:Eu, a yellow or red phosphor of (Sr,Ca)AlSiN₃:Eu, a red phosphor of Sr₂Si₅N₈:Eu, and the like.

Further, the aluminate phosphors may include a blue phosphor of (Sr,Ba)Al₂O₄:Eu, a blue phosphor of (Mg,Sr)Al₂O₄:Eu, a blue phosphor of BaMg₂Al₁₆O₂₇:Eu, and the like.

Further, the phosphor may include a fluoride phosphor.

For example, the fluoride phosphors may include phosphors represented by A₂SiF₆:Mn. Here, A may be an alkali metal element including potassium. For example, the fluoride phosphors may be a red phosphor of K₂SiF₆:Mn.

Further, the phosphor may include a manganese-containing fluoride phosphor of A₂[M₁₋ₐMnₐF₆]. Here, A may be at least one element selected from the group consisting of K, Li, Na, Rb, Cs, and NH₄. M may be at least one element selected from the group consisting of group IV elements and group XIV elements. a may be in the range of 0<a<0.2.

The manganese-containing fluoride phosphor (referred to as a KSF phosphor) is doped with tetravalent manganese ions and can emit red light having a wavelength of about 630 nm. Further, the manganese-containing fluoride phosphor has two peak wavelengths representing a color, thereby exhibiting an advantage of high color reproducibility.

In addition, the manganese-containing phosphor may include a red phosphor represented by (A₄₋ₐBₐ)_{m/2+n/2}X₂ₘ[MX₄O₂]ₙ based on an oxiodohalide host lattice. Here, A may be selected from the group consisting of hydrogen (H), deuterium (D) or mixtures thereof. B may be selected from the group consisting of Li, Na, K, Rb, Cs, NH₄, ND₄, NR₄, or mixtures thereof. R may be an alkyl or aryl radical. X may be selected from the group consisting of F, Cl or mixtures thereof. M may be selected from the group consisting of Cr, Mo, W, Re, or mixtures thereof. a, m and n may satisfy relations: 0 ≤ a ≤ 4, 0<m≤10, and 1≤n≤10.

The cyan phosphor may include at least one selected from among LuAG materials and silicate materials. Although the silicate phosphor emits cyan light, the silicate phosphor exhibits deterioration in reliability and luminous efficacy due to degradation when exposed to heat and moisture for a long period of time.

However, the cyan phosphor according to the embodiment of the invention may further improve reliability by further adding a LuAG material having high reliability to the silicate material. Accordingly, the cyan phosphor according to the embodiment of the invention may include both the silicate material and the LuAG material to emit cyan light having good reliability.

The cyan phosphor may further include a light absorbing material and may further include at least one of a tetravalent compound and a neodymium (Nd) material. For example, the neodymium material may be neodymium oxide.

FIG. 21 is a graph comparing light spectra of a first light emitting device and a second light emitting device.

Here, the first light emitting device 601 includes a phosphor consisting of the LuAG material and the second light emitting device 602 includes a phosphor comprising the LuAG material and a light absorbing material. In addition, the first light emitting device 601 and the second light emitting device 602 may include the same kind of light emitting chip emitting blue light. For example, the light absorbing material may be an Nd material, that is, neodymium oxide.

Referring to FIG. 21, the first light emitting device 601 has a light spectrum that has the highest peak at a wavelength of about 450 nm and a light intensity gradually decreasing in a wavelength band of about 470 nm or more, as compared to other wavelength bands.

In addition, the second light emitting device 602 has multiple inflection points in the light spectrum thereof. In particular, the second phosphor has the highest peak at a wavelength of about 450 nm and multiple inflection points even at a wavelength band of about 470 nm or more. Further, the second light emitting device 602 has the lowest light intensity at a wavelength of about 550 nm to about 600 nm in the light spectrum thereof. Comparing the light spectrum of the first light emitting device 601 with the light spectrum of the second light emitting device 602, the second light emitting device 602 has lower light intensity in the wavelength band of about 450 nm or more, in which the second light emitting device has the highest peak wavelength, than the first light emitting device 601. That is, it can be seen that the light absorbing material in the phosphor of the second light emitting device 602 absorbs some fractions of light emitted from the light emitting chip and the LuAG material.

In addition, the light spectrum of the second light emitting device 602 has a greater number of light inflection points than the light spectrum of the first light emitting device 601. That is, this is because the light absorbing material irregularly absorbs light in various wavelength bands instead of absorbing light in a particular wavelength band. The light spectrum of the second light emitting device 602 may have at least five inflection points.

Referring to FIG. 21, it can be seen that the light absorbing material reduces the intensity of light by absorbing a large quantity of light emitted from the light emitting chip and the LuAG material particularly in the wavelength band of about 500 nm to about 540 nm and in the wavelength band of about 570 nm to about 600 nm. In particular, it can be seen that the light intensity of the second light emitting device 602 is much lower than the light intensity of the first light emitting device 601 in the wavelength band of about 570 nm to about 600 nm, as compared to other wavelength bands. That is, it can be seen that the light absorbing material absorbs a greater quantity of light in the wavelength band of about 570 nm to about 600 nm than in other wavelength bands. Accordingly, the light spectrum of the second light emitting device 602 has an inflection point of low light intensity in the wavelength band of about 550 nm to about 600 nm. That is, the inflection points are formed in a region under an imaginary line L1 having a curvature at a wavelength of 610 nm to 650 nm and extending to a short wavelength of 550 nm. In addition, with reference to the inflection point of the lowest light intensity (the inflection point formed at a wavelength of 550 nm to 600 nm), the spectrum peaks in a wavelength band at the right may have a lower height than the spectrum peaks in a wavelength band at the left. Since the inflection points allow wavelength division despite the low height of the peaks, it is possible to realize sophisticated cyan light.

In particular, since the light absorbing material absorbs a greater quantity of light in the yellow wavelength band than in the blue and green wavelength bands, the phosphor containing the light absorbing material may realize more sophisticated cyan light.

Further, referring to FIG. 21, it can be seen that the light spectrum of the second light emitting device 602 has lower light intensity than the light spectrum of the first light emitting device 601 and the peak wavelength thereof has a narrow half-width.

Further, the light spectrum of the second light emitting device 602 has lower light intensity at a tail portion of about 550 nm or more than the light spectrum of the first light emitting device 601. That is, as compared to wavelengths of light making up cyan light, the light spectrum of the second light emitting device 602 has fewer wavelengths of light unrelated to cyan light than the light spectrum of the first light emitting device 601, thereby improving purity of cyan light.

As such, the light absorbing material may improve color purity of light emitted from the light emitting device.

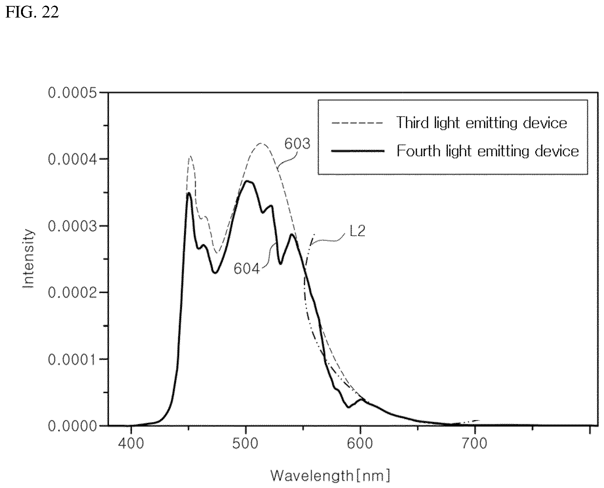

FIG. 22 is a graph comparing light spectra of a third light emitting device and a fourth light emitting device.

Here, the third light emitting device 603 includes a phosphor consisting of the LuAG material and the silicate material, and the fourth light emitting device 604 include a phosphor including the LuAG material, the silicate material and the light absorbing material. In addition, the third light emitting device 603 and the fourth light emitting device 604 include the same light emitting chip emitting blue light. For example, the light absorbing material may be an Nd material, that is, neodymium oxide.

A light emitting device including the phosphor prepared by mixing the LuAG material with the silicate material has better reliability than the light emitting device including the phosphor consisting of the silicate material. For example, when the content of the LuAG material is equal to or greater than 70% of the total content of the phosphors, it is effective in improvement in reliability of the light emitting device.

Referring to FIG. 22, the light spectrum of the third light emitting device 603 has inflection points or peak wavelengths at a wavelength of 460 nm to 480 nm and at a wavelength of about 510 nm to 530 nm.

Further, the light spectrum of the fourth light emitting device 604 has a greater number of inflection points than the third light emitting device 603. The fourth light emitting device 604 has higher peaks at a wavelength of about 450 nm to about 480 nm and at a wavelength of about 500 nm to about 520 nm. Further, the light spectrum of the fourth light emitting device 604 has multiple inflection points in other wavelength bands. That is, it can be seen that the light absorbing material irregularly absorbs light emitted from the light emitting chip and the LuAG material in various wavelength bands. Further, it can be seen that the light absorbing material absorbs a greater quantity of yellow light in the wavelength of about 570 nm to about 600 nm than in other wavelength bands. Accordingly, the light spectrum of the fourth light emitting device 604 has inflection points of low intensity at a wavelength of about 600 nm. That is, the inflection points are formed in a region under an imaginary line L2 having a curvature in the wavelength band of 610 nm to 650 nm and extending to a short wavelength (550 nm). As such, since the inflection points allow wavelength division despite the low height of the peaks, it is possible to realize sophisticated cyan light.

From FIG. 20 and FIG. 22, it can be seen that more sophisticated cyan light can be realized through improvement in purity of cyan light when the light absorbing material is added to the cyan phosphor.

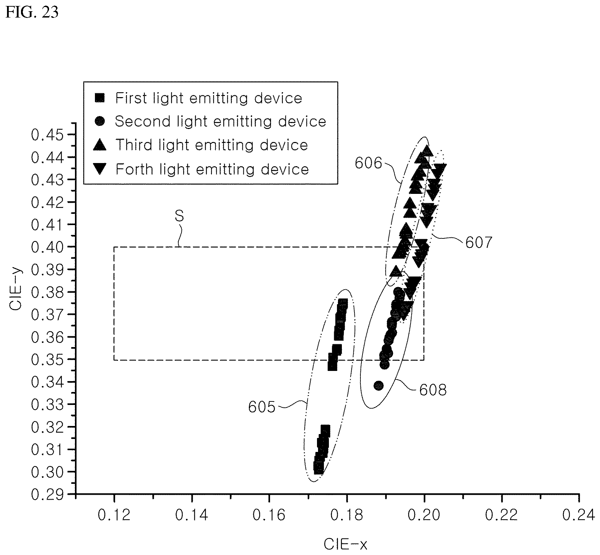

FIG. 23 is a graph depicting color coordinates of cyan phosphors according to various embodiments of the present invention.

The standard range (S) of the color coordinates (CIE(X, Y)) of cyan light is in the range of 0.12 to 0.20 for X and in the range of 0.35 to 0.40 for Y.

The first light emitting device 605 includes a phosphor composed of the silicate material. The second light emitting device 606 includes a phosphor prepared by mixing the LuAG material and the silicate material in a ratio of 5:5. The third light emitting device 607 includes a phosphor prepared by mixing the LuAG material and the silicate material in a ratio of 6:4. Further, the fourth light emitting device 608 includes a phosphor containing the LuAG material and the silicate material in a ratio of 7:3 and a small amount of the light absorbing material.

FIG. 23 shows the CIE color coordinates of light emitted from each of the first to fourth light emitting devices 605, 606, 607, 608.

Referring to FIG. 23, with reference to the color coordinates of light of the first light emitting device 605, light of the second to fourth light emitting devices 606, 607, 608 has color coordinate values increased in the X-axis and in the Y-axis. Such change in color coordinates may be caused by compensation of green light by the LuAG material.

Further, light of the fourth light emitting device 608 has lower color coordinate values decreased in the X-axis and in the Y-axis than light of the second light emitting device 606 and the third light emitting device 607. Further, most of the color coordinates of light measured through the fourth light emitting device 608 is included in the standard color coordinate range (S) of cyan light. It can be seen that this phenomenon occurs because the light absorbing material absorbs some fractions of blue light and some fractions of yellow light.

As such, sophisticated cyan light having such a CIE coordinate range may be realized by applying the phosphor prepared by mixing the silicate material, the LuAG material and the light absorbing material to the light emitting device.

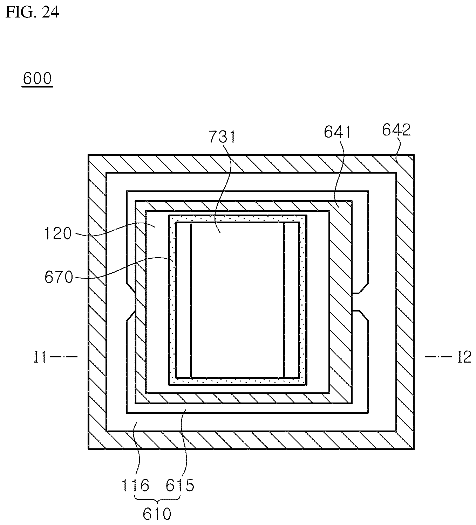

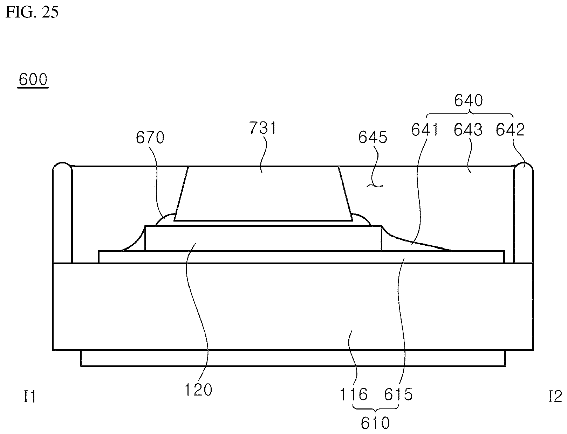

FIG. 24 and FIG. 25 are exemplary views of a light emitting device according to a sixth embodiment of the present invention. FIG. 24 is a plan view of the light emitting device according to the sixth embodiment of the present invention. In addition, FIG. 25 is a cross-sectional view (I1-I2) of the light emitting device according to the sixth embodiment of the present invention.

Referring to FIG. 24 and FIG. 25, the light emitting device 600 may include a substrate 610, a light emitting chip 120, a light transmitting member 731, and a barrier member 640. In addition, the light emitting device 600 according to this embodiment may further include a bonding layer 670 that bonds the light emitting chip 120 to the light transmitting member 731.

It should be understood that the light transmitting member 731 according to this embodiment is not limited to the structure shown in FIG. 24 and FIG. 25. The light transmitting member 731 according to this embodiment may be formed through combination of the structures and components of the light transmitting members described in the above embodiments.

In other embodiments including this embodiment, the substrate 610 is not limited to the structures shown in the corresponding drawings. The substrate 610 may have any structure including the insulating layer 116 and the electrically conductive pattern 615, which is electrically connected to the light emitting chip 120. In addition, the structure of the electrically conductive pattern 615 may be modified in various ways.

According to this embodiment, the bonding layer 670 may be interposed between the light emitting chip 120 and the light transmitting member 731. In addition, referring to FIG. 24 and FIG. 25, a portion of the bonding layer 670 may cover the upper surface of the light emitting chip 120 exposed by the light transmitting member 731. In addition, the portion of the bonding layer 670 covering the upper surface of the light emitting chip 120 may cover a portion of the side surfaces of the light transmitting member 731, as shown in FIG. 25.

The bonding layer 670 may be formed of a material allowing transmission of light emitted from the light emitting chip 120. For example, the bonding layer 670 may be formed of transparent silicone.

In addition, the light emitting device 600 according to this embodiment may include multiple barrier members on the substrate 610. According to this embodiment, the barrier member 640 may include first to third barrier members 641, 642, 643.

The first barrier member 641 may be formed to cover the side surfaces of the light emitting chip 120. For example, an upper end of the first barrier member 641 may be placed at an upper end of the side surfaces of the light emitting chip 120. That is, the first barrier member 641 may be formed to cover the entirety of the side surfaces of the light emitting chip 120.

In addition, an outer surface of the first barrier member 641 may be an inclined surface with an inclination. For example, the first barrier member 641 may have a thickness gradually increasing from an upper surface thereof to a lower surface thereof. Here, the outer surface of the first barrier member 641 may have a flat surface or a curved surface. Further, when the outer surface of the first barrier member 641 is a curved surface, the outer surface thereof may have an upwardly convex or downwardly concave structure.

The second barrier member 642 may be formed along the periphery of the substrate 610 on the substrate 610. Further, the second barrier member 642 may have a cavity in which the light emitting chip 120 and the light transmitting member 731 are disposed. Here, an inner surface of the second barrier member 642 may be spaced apart from the light emitting chip 120 and the light transmitting member 731. Further, the entire inner surface of the second barrier member 642 may be spaced apart from the first barrier member 641. In addition, the inner surface of the second barrier member 642 may at least partially contact the first barrier member 641.

Further, an upper surface of the second barrier member 642 may have an upwardly convex structure. However, the structure of the second barrier member 642 is not limited thereto. That is, the upper surface of the second barrier member 642 may have a flat structure.

The second barrier member 642 may serve to prevent the third barrier member 643 from flowing outwards from the upper surface of the substrate 610 upon formation of the third barrier member 643. That is, the second barrier member 642 may guide a material of the third barrier member 643 to cover components in the cavity excluding the upper surface of the light transmitting member 731 by filling the cavity of the second barrier member 642 with the material of the third barrier member 643.

The third barrier member 643 may cover the upper surface of the substrate 610 exposed by the third barrier member 643, the light emitting chip 120 and the light transmitting member 731 by filling the cavity of the second barrier member 642. In addition, when the first barrier member 641 is formed, the third barrier member 643 may also cover the first barrier member 641. Here, the third barrier member 643 may expose the upper surface of the light transmitting member 731, which corresponds to the light exit surface of the light emitting device 600. For example, an upper surface of the third barrier member 643 may be placed coplanar with the upper surface of the light transmitting member 731. In addition, when the third barrier member 643 covers all of the side surfaces of the light transmitting member 731 while exposing the upper surface of the light transmitting member 731, the third barrier member 643 may have a structure wherein the entire supper surface of the third barrier member 643 is not placed coplanar with the upper surface of the light transmitting member 731.

The third barrier member 643 may protect the electrically conductive pattern 615, the light emitting chip 120, and the light transmitting member 731 formed on the upper surface of the substrate 610 from an external environment of the light emitting device 600 by filling the cavity of the second barrier member 642.

The first to third barrier members 641, 642, 643 may be formed of any material capable of protecting inner components of the light emitting device 600. For example, the first to third barrier members 641, 642, 643 may be formed of a silicone resin. Further, at least one of the first to third barrier members 641, 642, 643 may further include a reflective material. The barrier member 640 containing the reflective material may reflect light emitted from the light emitting chip 120.

For example, the first barrier member 641 may further include the reflective material. Here, the first barrier member 641 may reflect light emitted through the side surfaces of the light emitting chip 120 such that light of the light emitting chip 120 can be discharged through the upper surface thereof. Accordingly, the first barrier member 641 may guide light of the light emitting chip 120 to enter the light transmitting member 731 through the upper surface of the light emitting chip 120. For example, the reflective material may be TiO₂.

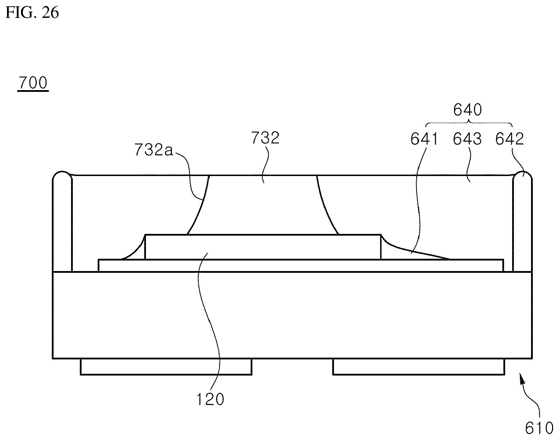

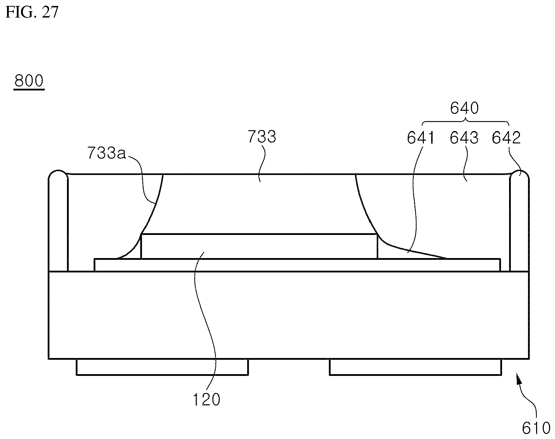

FIG. 26 is an exemplary view of a light emitting device according to a seventh embodiment of the present invention and FIG. 27 is an exemplary view of a light emitting device according to an eighth embodiment of the present invention.

FIG. 26 shows a cross-section of the light emitting device 700 according to the seventh embodiment and FIG. 27 shows a cross-section of the light emitting device 800 according to the eighth embodiment.

Each of the light emitting devices 700, 800 according to the seventh and eighth embodiments includes a light transmitting member 732; 733 having opposite side surfaces 732a; 733a facing each other and composed of curved surfaces. For example, for the light transmitting member 732; 733, one pair of side surfaces 732a; 733a facing each other has a concave structure and the other pair of side surfaces 732a is perpendicular to a lower surface of the light transmitting member 732; 733.

Referring to FIG. 26, in the light emitting device 700 according to the seventh embodiment, the light transmitting member 732 covers a portion of the upper surface of the light emitting chip 120. The lower surface of the light transmitting member 732 has a smaller area than the upper surface of the light emitting chip 120 and a lower surface periphery of the light transmitting member 732 is placed inside an upper surface periphery of the light emitting chip 120.

Referring to FIG. 27, in the light emitting device 800 according to the eighth embodiment, the light transmitting member 733 is formed to cover the entire upper surface of the light emitting chip 120. For example, the lower surface of the light transmitting member 733 may have the same area as the upper surface of the light emitting chip 120. Referring to FIG. 27, the lower surface periphery of the light transmitting member 733 is placed on the upper surface periphery of the light emitting chip 120.

However, it should be understood that the structures of the light emitting devices 700, 800 according to these embodiments are not limited thereto. For example, each of the light emitting devices 700, 800 according to these embodiments may have a structure wherein the lower surface of each of the light transmitting members 732, 733 has a greater area than the upper surface of the light emitting chip 120 and the lower surface periphery of each of the light transmitting members 732, 733 is placed outside the light emitting chip 120.

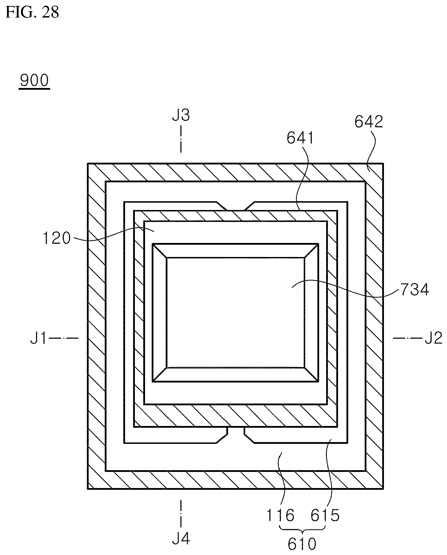

FIG. 28 to FIG. 30 are exemplary views of a light emitting device according to a ninth embodiment of the present invention.

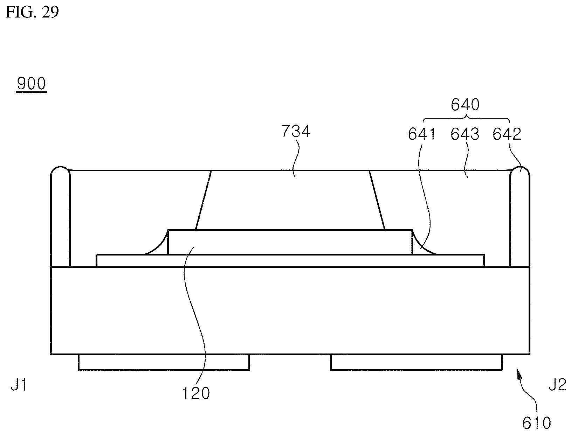

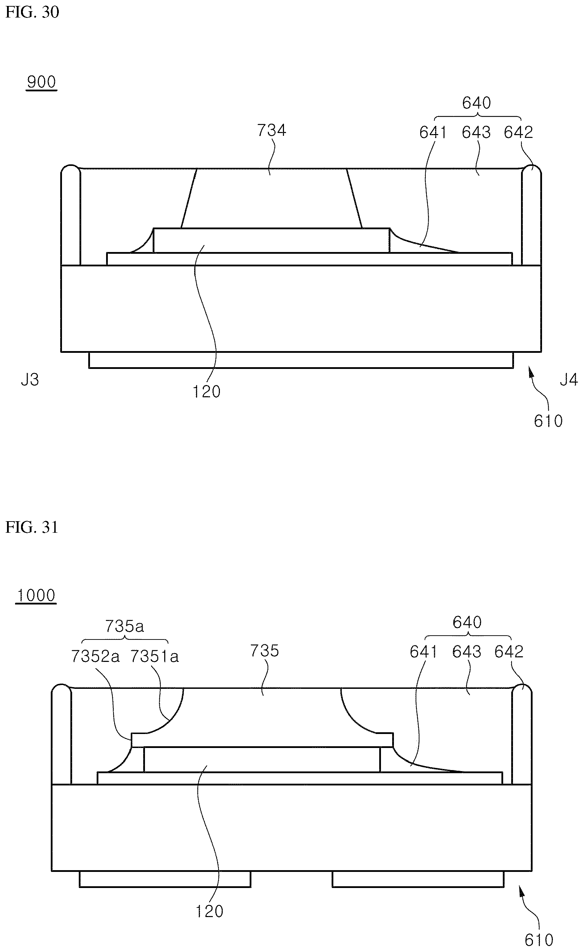

FIG. 28 is a plan view of a light emitting device 900 according to the ninth embodiment. FIG. 29 is a cross-sectional view (J1-J2) of the light emitting device 900 according to the ninth embodiment. In addition, FIG. 30 is another cross-sectional view (J3-J3) of the light emitting device 900 according to the ninth embodiment.

The light emitting device 900 according to the ninth embodiment may include a light transmitting member 734, all side surfaces of which are inclined surfaces. Further, referring to FIG. 29 and FIG. 30, the light transmitting member 734 has a structure in which a distance between opposite side surfaces thereof gradually increases from an upper surface thereof to a lower surface thereof. With this structure, the light transmitting member 734 has a cross-sectional area gradually increasing from the upper surface thereof to the lower surface thereof. Further, referring to FIG. 28, the light transmitting member 734 has an upper surface periphery placed inside a lower surface periphery thereof.

Referring to FIG. 28 to FIG. 30, in the light emitting device 900 according to this embodiment, the lower surface of the light transmitting member 734 has a smaller cross-sectional area than the upper surface of the light emitting chip 120. However, it should be understood that the structure of the light emitting device 900 according to this embodiment is not limited thereto. For example, the light emitting device 900 according to this embodiment may have a structure wherein the lower surface of the light transmitting member 734 has the same cross-sectional area as or a larger cross-sectional area than the upper surface of the light emitting chip 120.

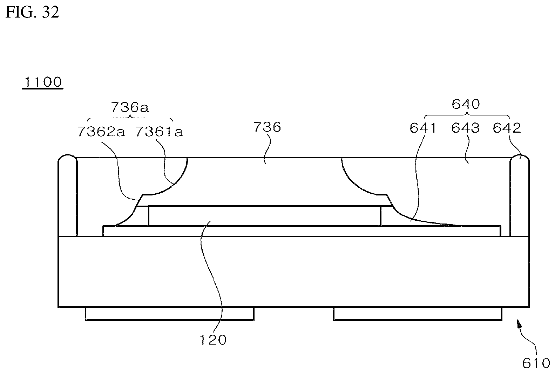

FIG. 31 is an exemplary view of a light emitting device according to a tenth embodiment of the present invention. In addition, FIG. 32 is an exemplary view of a light emitting device according to an eleventh embodiment of the present invention.

FIG. 31 is a cross-sectional view of a light emitting device 1000 according to the tenth embodiment and FIG. 32 is a cross-sectional view of the light emitting device 1100 according to the eleventh embodiment.

Each of the light emitting devices 1000, 1100 according to the ninth and eleventh embodiments may include a light transmitting member 735; 736 in which side surfaces 735a; 736a each include a curved surface 7351a; 7361a and a flat surface 7352a; 7362a. Referring to FIG. 31 and FIG. 32, in each of the light transmitting members 735; 736, each side surface 735a; 736a may have a structure in which the curved surface 7351a; 7361a is placed on the flat surface 7352a; 7362a.

Referring to FIG. 31, according to the tenth embodiment, the flat surface 7352a of the side surface 735a of the light transmitting member 735 is perpendicular to the lower surface of the light transmitting member 735.

Referring to FIG. 32, according to the eleventh embodiment, the flat surface 7362a of the side surface 736a of the light transmitting member 736 is inclined with respect to the lower surface of the light transmitting member 736. For example, the light transmitting member 736 may have a structure wherein the distance between the flat surfaces 7362a of the side surfaces 736a facing each other gradually increases in the downward direction.

Further, in the light emitting devices 1000, 1100 according to the tenth and eleventh embodiments, the lower surface of the light transmitting member 735; 736 may have a larger area than the upper surface of the light emitting chip 120. Accordingly, a lower surface periphery of the light transmitting member 735; 736 may be placed outside the light emitting chip 120.

Further, according to the tenth and eleventh embodiments, the upper surface of the light transmitting member 735; 736 may be formed to have a smaller area than the lower surface thereof. Here, the upper surface of the light transmitting member 735; 736 may have a smaller area than the upper surface of the light emitting chip 120.

Accordingly, in the light emitting devices 1000, 1100 according to the tenth and eleventh embodiments, the upper surface periphery of the light emitting chip 120 may be placed between the lower surface periphery and the upper surface periphery of the light transmitting member 735; 736.

Further, according to the tenth and eleventh embodiments, the first barrier member 641 may be formed to cover the lower surface of the light transmitting member 735; 736 and the side surfaces of the light emitting chip 120. Accordingly, the first barrier member 641 may have an upper end placed at the lower surface periphery of the light transmitting member 735; 736. In addition, the upper end of the first barrier member 641 may be placed on the side surface of the light transmitting member 735; 736. Here, the first barrier member 641 may cover at least part of the side surface of the light transmitting member 735; 736.

Although the light transmitting members 735, 736 according to the tenth and eleventh embodiments are described as having the structure wherein all of the side surfaces thereof include the curved surface and the flat surface, it should be understood that the present invention is not limited thereto. The light transmitting members 735, 736 may have a structure wherein only the pair of side surfaces facing each other is composed of a curved surface and a flat surface. Further, in each of the light transmitting members 735, 736, the pair of side surfaces facing each other may have a periphery placed outside the periphery of the upper surface of the light emitting chip 120. Here, the other pair of side surfaces of each of the light transmitting members 735, 736 may have a periphery placed above the periphery of the upper surface of the light emitting chip 120 or inside the upper surface thereof.

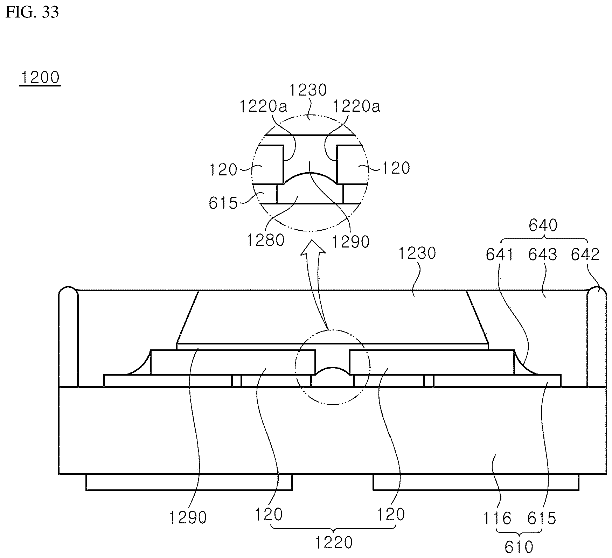

FIG. 33 is an exemplary view of a light emitting device according to a twelfth embodiment of the present invention.

FIG. 33 shows a cross-section of the light emitting device according to the twelfth embodiment of the present invention.

The light emitting device 1200 according to the twelfth embodiment may include a light emitting part 1220 composed of multiple light emitting chips 120 and a light transmitting member 1230 covering an upper surface of the light emitting part 1220. A lower surface of the light transmitting member 1230 may have a smaller area than an upper surface of the light emitting part 1220. Accordingly, the light transmitting member 1230 may have a lower surface periphery placed inside an upper surface periphery of the light emitting part 1220.

Further, the light emitting device 1200 according to this embodiment may further include a reflective member 1280 between the multiple light emitting chips 120. Referring to FIG. 33, the reflective member 1280 may be formed on an upper surface of the substrate 610 and may have an upwardly convex structure. The reflective member 1280 may reflect light emitted from side surfaces 1220a of the light emitting chips 120, which face each other. The convex structure of the reflective member 1280 may guide light reflected by the reflective member 1280 to travel towards the light transmitting member 1230 placed above the reflective member 1280. Although FIG. 33 shows the reflective member 1280 having the convex structure, the reflective member 1280 may have any structure capable of guiding the reflected light to travel towards the light transmitting member 1230.

The reflective member 1280 may be formed of any material capable of reflecting light. For example, the reflective member 1280 may be formed of a resin containing a reflective material, such as TiO₂.

In this embodiment, the reflective member 1280 is illustrated as a separate member from the barrier member 640. However, the reflective member 1280 may have the same configuration as the barrier member 640. That is, the reflective member 1280 may be formed of the same material as the barrier member 640 capable of reflecting light through the same process as the barrier member 640 in the same manner.

A bonding agent 1290 may be further disposed between the reflective member 1280 and the light transmitting member 1230. Accordingly, the bonding agent 1290 can improve bonding strength between the multiple light emitting chips 120 and between the multiple light emitting chips 120 and the light transmitting member 1230. Further, the bonding agent 1290 may be formed of a light transmissive material. Accordingly, light reflected by the reflective member 1280 may enter the light transmitting member 1230 through the bonding agent 1290.

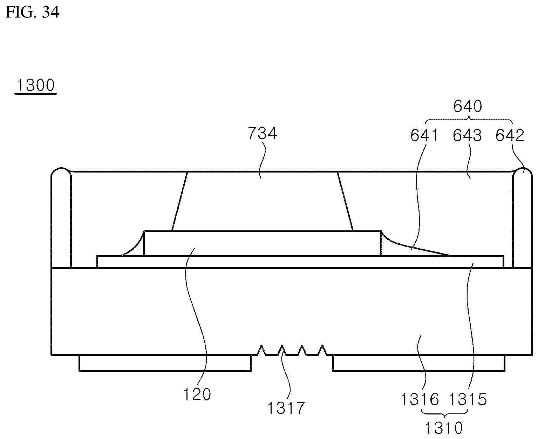

FIG. 34 is an exemplary view of a light emitting device according to a thirteenth embodiment of the present invention.

Referring to FIG. 34, the light emitting device 1300 according to the thirteenth embodiment may include a substrate 1310 having at least one groove 1317 on a lower surface thereof. The grooves 1317 formed on the substrate 1310 may be a heat dissipation pattern.

According to this embodiment, a contact area between the substrate 1310 and air is increased by the grooves 1317 formed on the substrate 1310. That is, a heat dissipation area of the light emitting device 1300 through which heat generated from the light emitting device 1300 is discharged to air may increase. The light emitting device 1300 including the substrate 1310 having the grooves 1317 may achieve improvement in luminous efficacy.

In addition, the grooves 1317 may be further formed not only on the lower surface of the substrate 1310 but also on a side surface thereof exposed to air. Accordingly, the heat dissipation area of the light emitting device 1300 may be increased, thereby further improving heat dissipation efficiency.

The structures of the light emitting devices according to various embodiments of the present invention described with reference to the accompanying drawings are not limited to the structures illustrated herein. The light emitting devices of the present invention may include any combination of the structures, components, and features of the configurations included in the light emitting devices according to the various embodiments of the invention described above.

Although some embodiments have been described herein with reference to the accompanying drawings, it should be understood that the foregoing embodiments are provided for illustration only and are not to be in any way construed as limiting the technical idea of the present invention. The scope of the present invention should be defined by the appended claims and equivalents thereto.

## Claims

1. A light emitting device comprising:
a substrate having an electrically conductive pattern formed thereon;
a light generating part mounted on the substrate to be electrically connected to the electrically conductive pattern and generating light;
a first light emitting part formed on the light generating part;
a second light emitting part formed on the first light emitting part and comprising a support member through which light is transmitted and particles dispersed in the support member; and
a barrier member formed on an upper surface of the substrate and surrounding the light generating part, the first light emitting part and the second light emitting part,
wherein the barrier member exposes at least part of an upper surface of the second light emitting part, and
the first light emitting part and the second light emitting part comprise at least one identical material.

2. The light emitting device according to claim 1, wherein a spectrum of light emitted from the light emitting device comprises an inflection point formed in a region under an imaginary line having a curvature at a wavelength of 610 nm to 650 nm and extending to a wavelength of 550 nm.

3. The light emitting device according to claim 1, wherein the first light emitting part and the second light emitting part comprise a material having the same index of refraction.

4. The light emitting device according to claim 3, wherein a region having a different index of refraction than an index of refraction of the first light emitting part and the second light emitting part is formed between the first light emitting part and the second light emitting part.

5. The light emitting device according to claim 1, wherein the particles comprise first particles and second particles, the first particles comprising a LuAG material or a LuAG material and a silicate material.

6. The light emitting device according to claim 5, wherein the particles comprise first particles and second particles, the second particles comprising an Nd (neodymium) material.

7. The light emitting device according to claim 1, wherein the particles comprise first particles and second particles, and some of the first particles contact some of the second particles.

8. The light emitting device according to claim 1, wherein an upper surface of the second light emitting part has a smaller cross-sectional area than a lower surface thereof.

9. The light emitting device according to claim 8, wherein the second light emitting part comprises a pair of first side surfaces facing each other and another pair of second side surfaces facing each other, and the pair of first side surfaces is composed of inclined surfaces with an inclination.

10. The light emitting device according to claim 9, wherein the pair of first side surfaces comprises at least one of a curved surface and a flat surface.

11. The light emitting device according to claim 8, wherein the lower surface of the second light emitting part has a smaller area than an upper surface of the first light emitting part.

12. The light emitting device according to claim 11, wherein at least part of a lower surface periphery of the second light emitting part is placed inside an upper surface periphery of the first light emitting part.

13. The light emitting device according to claim 8, wherein the lower surface of the second light emitting part has the same area as or a larger area than an upper surface of the first light emitting part.

14. The light emitting device according to claim 1, wherein the barrier member comprises:
a first barrier member covering the light generating part and a side surface of the first light emitting part;
a second barrier member formed along a periphery of the substrate and forming a cavity in which the light generating part, the first light emitting part, the second light emitting part and the first barrier member are placed; and
a third barrier member filling the cavity of the second barrier member.

15. The light emitting device according to claim 1, wherein the barrier member comprises a reflective material.

16. The light emitting device according to claim 14, wherein at least one of the first barrier member, the second barrier member and the third barrier member comprises a reflective material.

17. The light emitting device according to claim 16, wherein the first barrier member comprises a reflective material.

18. The light emitting device according to claim 1, further comprising:
a reflective member covering a side surface of the second light emitting part.

19. The light emitting device according to claim 1, wherein the light generating part is provided singularly or in plural.

20. The light emitting device according to claim 1, wherein the first light emitting part emits light having color coordinates (X, Y) in which X is in the range of 0.12 to 0.20 and Y is in the range of 0.35 to 0.40.
